(19) Europäisches Patentamt
European Patent Office
Office européen des brevets

(11) **EP 3 515 611 B1**

(12) **EUROPEAN PATENT SPECIFICATION**

(45) Date of publication and mention
of the grant of the patent:
**31.12.2025 Bulletin 2026/01**

(21) Application number: **16916051.2**

(22) Date of filing: **19.09.2016**

(51) International Patent Classification (IPC):
**B08B 3/12** (2006.01)

(52) Cooperative Patent Classification (CPC):
**B08B 3/12; B06B 1/0269; H01L 21/67057;**
B06B 2201/71

(86) International application number:
**PCT/CN2016/099303**

(87) International publication number:
**WO 2018/049671 (22.03.2018 Gazette 2018/12)**

(54) **METHODS AND APPARATUS FOR CLEANING SUBSTRATES**

VERFAHREN UND VORRICHTUNG ZUR REINIGUNG VON SUBSTRATEN

PROCÉDÉS ET APPAREIL DE NETTOYAGE DE SUBSTRATS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**31.07.2019 Bulletin 2019/31**

(73) Proprietor: **ACM Research (Shanghai) Inc.**
Shanghai 201203 (CN)

(72) Inventors:
• **WANG, Hui**
Shanghai 201203 (CN)
• **WANG, Xi**
Shanghai 201203 (CN)
• **CHEN, Fuping**
Shanghai 201203 (CN)
• **CHEN, Fufa**
Shanghai 201203 (CN)
• **WANG, Jian**
Shanghai 201203 (CN)
• **ZHANG, Xiaoyan**
Shanghai 201203 (CN)
• **JIN, Yinuo**
Shanghai 201203 (CN)
• **JIA, Zhaowei**
Shanghai 201203 (CN)
• **WANG, Jun**
Shanghai 201203 (CN)
• **LI, Xuejun**
Shanghai 201203 (CN)

(74) Representative: **Osha BWB**
**2, rue de la Paix**
**75002 Paris (FR)**

(56) References cited:
EP-A1- 3 298 622        WO-A1-2008/096696
CN-U- 203 816 979      JP-A- 2007 326 088
KR-B1- 100 899 875     US-A1- 2006 260 641
US-A1- 2009 025 761    US-A1- 2010 224 214
US-A1- 2013 119 015    US-A1- 2014 216 508

**Description**

FIELD OF THE INVENTION

The present invention generally relates to a method and an apparatus for cleaning a substrate. More particularly, the present invention relates to controlling the bubble cavitation generated by an ultra or mega sonic device during a cleaning process to achieve a stable or controlled cavitation on the entire substrate, which removes fine particles efficiently in vias, trenches or recessed areas with high aspect ratio.

BACKGROUND

Semiconductor devices are manufactured or fabricated on semiconductor substrates using a number of different processing steps to create transistor and interconnection elements. Recently, transistors have been built from two dimensions to three dimensions such as finFET transistors and 3D NAND memory. To electrically connect transistor terminals associated with the semiconductor substrate, conductive (e.g., metal) trenches, vias, and the like are formed of dielectric materials as part of the semiconductor device. The trenches and vias couple electrical signals and power between transistors, internal circuits of the semiconductor devices, and circuits external to the semiconductor device.
In forming the finFET transistors and interconnection elements on the semiconductor substrate, for example, masking, etching, and deposition processes may be performed to form the desired electronic circuitry of the semiconductor devices. In particular, multiple masking and plasma etching step can be performed to form a pattern of finFET, 3D NAND flash cell and or recessed areas of a dielectric layer on a semiconductor substrate that serve as fin for the transistor and/or trenches and vias for the interconnection elements. In order to remove particles and contaminations in a fin structure and/or trench and via post etching or photo resist ashing, a wet cleaning step is necessary. Especially, when a device manufacture node migrates to 14 or 16 nm and beyond, the side wall loss in a fin and/or trench and via is crucial for maintaining the critical dimension. In order to reduce or eliminate the side wall loss, it is important to use moderate, diluted chemicals, or sometime de-ionized water only. However, the diluted chemical or de-ionized water usually is not efficient to remove the particles in the fin structure, 3D NAND hole and/or trench and via. Therefore, a mechanical force such as ultra or mega sonic is needed in order to remove those particles efficiently. Ultra sonic or mega sonic wave will generate bubble cavitation, which applies mechanical force to the substrate structure, the violent cavitation such as transit cavitation or micro jet will damage those patterned structures. To maintain a stable or controlled cavitation is a key parameter to control the mechanical force within the damage limit and at the same time to efficiently remove the particles. In the 3D NAND hole structure, the transit cavitation may not damage the hole structure, but however, the bubble cavitation saturated inside a hole will stop or reduce the cleaning effects.
Mega sonic energy coupled with nozzle to clean semiconductor wafer is disclosed in U.S. Pat. No. 4,326,553. The fluid is pressurized and mega sonic energy is applied to the fluid by a mega sonic transducer. The nozzle is shaped to provide a ribbonlike jet of cleaning fluid vibrating at ultra/mega sonic frequencies for the impingement on the surface.
A source of energy vibrates an elongated probe which transmits the acoustic energy into the fluid is disclosed in U.S. Pat. No. 6,039,059. In one arrangement, fluid is sprayed onto both sides of a wafer while a probe is positioned close to an upper side. In another arrangement, a short probe is positioned with its end surface close to the surface, and the probe is moved over the surface as wafer rotates.
A source of energy vibrates a rod which rotates around its axis parallel to wafer surface is disclosed in U.S. Pat. No. 6,843,257 B2. The rod surface is etched to curve groves, such as spiral groove.
EP 3 298 622 A1 is a document according to Art. 54(3) EPC and describes an apparatus and a method for cleaning semiconductor substrates without damaging a patterned structure on a substrate using an ultra/mega sonic device. The method comprises: applying liquid into a space between a substrate and an ultra/mega sonic device; setting an ultra/mega sonic power supply at frequency f1 and power P1 to drive the ultra/mega sonic device; before bubble cavitation in said liquid damaging patterned structure on the substrate, setting said ultra/mega sonic power supply at frequency f2 and power P2 to drive said ultra/mega sonic device; after temperature inside bubble cooling down to a set temperature, setting said ultra/mega sonic power supply at frequency f1 and power P1 again; and repeating the above steps until the substrate is cleaned. Normally, if f1 =f2, then P2 is equal to zero or much less than P1; if P1=P2, then f2 is higher than f1; if the f1<f2, then, P2 can be either equal or less than P1.
US 2014/216508 A1 describes a system, an apparatus and a method for processing substrates using acoustic energy. A system for processing flat articles comprises: a support supporting a flat article; a dispenser applying liquid to a first surface of the flat article; a transducer assembly comprising: a transmitting structure having a longitudinal axis; a first set of transducers acoustically coupled to the transmitting structure in a spaced apart manner on a first side of the longitudinal axis; a second set of transducers acoustically coupled to the transmitting structure in a spaced apart manner on a second side of the longitudinal axis; the transducers of the first and second sets staggered along the longitudinal axis. When the dispenser applies liquid to the first surface of the flat article, a film of liquid is formed between the transmitting structure and the first surface of the flat article.

There is a need to have a better method for controlling the bubble cavitation generated by ultra or mega sonic device during the cleaning process to achieve a stable or controlled cavitation on the entire substrate, which removes fine particles efficiently in vias, trenches or recessed areas with high aspect ratio.

## SUMMARY

In one aspect, the present invention relates to a method for cleaning vias, trenches or recessed areas on a substrate using an ultra/mega sonic device. The method comprises: applying liquid into a space between a substrate and an ultra/mega sonic device; setting an ultra/mega sonic power supply at a first frequency f1 and a first power $P_1$ to drive said ultra/mega sonic device during a first time interval; after a ratio of total bubbles volume to volume inside vias or recessed areas on the substrate increases to a first set value, setting said ultra/mega sonic power supply at a second frequency $f_2$ and a second power $P_2$ to drive said ultra/mega sonic device during a second time interval; after the ratio of total bubbles volume to volume inside the vias, trenches or recessed areas reduces to a second set value, setting said ultra/mega sonic power supply at the first frequency $f_1$ and the first power $P_1$ again; and repeating the above steps until the substrate is cleaned.

Embodiments of the method of the present invention achieve a damage free ultra/mega-sonic cleaning on a wafer with a patterned structure by maintaining a stable bubble cavitation. The stable bubble cavitation is controlled by setting a sonic power supply with power $P_1$ for a time interval shorter than $\tau_1$, and setting the sonic power supply with power $P_2$ for a time interval longer than $\tau_2$, and repeat above steps until the wafer is cleaned, where power $P_2$ is equal to zero or much smaller than power $P_1$, $\tau_1$ is a time interval in which the temperature inside bubble raises to a critical implosion temperature; and $\tau_2$ is a time interval in which the temperature inside bubble falls down to a temperature much lower than the critical implosion temperature.

Embodiments of the method of the present invention achieve a damage free ultra/mega sonic cleaning on a wafer with a patterned structure by maintaining a stable bubble cavitation. The stable bubble cavitation is controlled by setting a sonic power supply with a frequency $f_1$ for a time interval shorter than $\tau_1$, and setting the sonic power supply with a frequency $f_2$ for a time interval longer than $\tau_2$, and repeat the above steps until the wafer is cleaned, where $f_2$ is much higher than $f_1$, better 2 times or 4 times higher, $\tau_1$ is a time interval in which the temperature inside the bubble raises to a critical implosion temperature; and $\tau_2$ is a time interval in which the temperature inside the bubble falls down to a temperature much lower than the critical implosion temperature.

Embodiments of the method of the present invention achieve a damage free ultra/mega-sonic cleaning on a wafer with a patterned structure by maintaining a stable bubble cavitation with a bubble size less than space in the patterned structure. The stable bubble cavitation with a bubble size less than space in the patterned structure is controlled by setting a sonic power supply at power $P_1$ for a time interval shorter than $\tau_1$, and setting the sonic power supply at power $P_2$ for a time interval longer than $\tau_2$, and repeat the above steps until the wafer is cleaned, where $P_2$ is equal to zero or much smaller than $P_1$, $\tau_1$ is a time interval in which the bubble size increases to a critical size equal to or larger than the space in patterned structures; and $\tau_2$ is a time interval in which the bubble size decreases to a value much smaller than the space in patterned structure.

Embodiments of the method of the present invention achieve a damage free ultra/mega-sonic cleaning on a wafer with a patterned structure by maintaining a stable bubble cavitation with a bubble size less than the space in the patterned structure. The stable bubble cavitation with a bubble size less than the space in the patterned structure is controlled by setting a sonic power supply with a frequency $f_1$ for a time interval shorter than $\tau_1$, and setting the sonic power supply with a frequency $f_2$ for a time interval longer than $\tau_2$, and repeat the above steps until the wafer is cleaned, where $f_2$ is much higher than $f_1$, better 2 times or 4 times higher, $\tau_1$ is a time interval in which the bubble size increases to a critical size equal to or larger than the space in the patterned structure; and $\tau_2$ is a time interval in which the bubble size decreases to a value much smaller than the space in the patterned structure.

Embodiments of the method of the present invention achieve an effective ultra/mega-sonic cleaning on a substrate with features of deep holes by maintaining a non-saturated bubble cavitation. The non-saturated bubble cavitation is controlled by setting a sonic power supply with a power $P_1$ for a time interval shorter than $\tau_1$, and setting the sonic power supply with a power $P_2$ for a time interval longer than $\tau_2$, and repeating above steps until the substrate is cleaned, where power $P_2$ is equal to zero or much smaller than power $P_1$, $\tau_1$ is a time interval in which the cavitation or bubble density inside the deep hole raises to saturated status; and $\tau_2$ is a time interval in which bubble density falls down to a level much lower than the saturated status.

Embodiments of the method of the present invention achieve an effective ultra/mega-sonic cleaning on a substrate with features of deep holes by maintaining a non-saturated bubble cavitation. The non-saturated bubble cavitation is controlled by setting a sonic power supply with a frequency $f_1$ for a time interval shorter than $\tau_1$, and setting the sonic power supply with a frequency $f_2$ for a time interval longer than $\tau_2$, and repeating the above steps until the substrate is cleaned, where $f_2$ is much higher than $f_1$, better 2 times or 4 times higher, $\tau_1$ is a time interval in which the cavitation or bubble density inside the deep hole raises to a saturated status; and $\tau_2$ is a time interval in which bubble density falls down to a level much lower than the saturated status.

Embodiments of the method of the present invention achieve an effective ultra/mega-sonic cleaning on a substrate with features of deep holes by maintaining a certain size of bubble in cavitation status. The certain size of bubble in cavitation status is controlled by setting a sonic power supply with a power $P_1$ for a time interval shorter than $\tau_1$, and setting the sonic power supply with a power $P_2$ for a time interval longer than $\tau_2$, and repeating above steps until the substrate is cleaned, where power $P_2$ is equal to zero or much smaller than power $P_1$, $\tau_1$ is a time interval in which the cavitation or bubble density inside the deep hole raises to saturated status; and $\tau_2$ is a time interval in which bubble size falls down to a level much smaller than the certain size.

Embodiments of the method of the present invention achieve an effective ultra/mega-sonic cleaning on a substrate with features of deep holes by maintaining a certain size of bubble in cavitation status. The certain size of bubble in cavitation status is controlled by setting a sonic power supply with a frequency $f_1$ for a time interval shorter than $\tau_1$, and setting the sonic power supply with a frequency $f_2$ for a time interval longer than $\tau_2$, and repeating the above steps until the substrate is cleaned, where $f_2$ is much higher than $f_1$, better 2 times or 4 times higher, $\tau_1$ is a time interval in which the cavitation or bubble density inside the deep hole raises to saturated status; and $\tau_2$ is a time interval in which the bubble size falls down to a level much smaller than the certain size.

In another aspect, the present invention relates to an apparatus for cleaning a semiconductor wafer comprising features of as defined in claim 7.

Further embodiments of the method and the apparatus are defined in the dependent claims.

BRIEF DESCRIPTION OF THE DRAWINGS

FIGs.1A-1B depict an exemplary wafer cleaning apparatus using an ultra/mega sonic device;

FIGs.2A-2G depict ultra/mega sonic transducers with various shapes;

FIG. 3 depicts a bubble cavitation during a wafer cleaning process;

FIGs.4A-4B depict a transit cavitation damaging patterned structure on a wafer during a cleaning process;

FIGs.5A-5C depict a thermal energy variation inside the bubble during a cleaning process;

FIGs.6A-6C depict an exemplary wafer cleaning method;

FIGs.7A-7C depict another exemplary wafer cleaning method;

FIGs.8A-8D depict another exemplary wafer cleaning method;

FIGs.9A-9D depict another exemplary wafer cleaning method;

FIGs. 10A-10B depict another exemplary wafer cleaning method;

FIGs.11A-11B depict another exemplary wafer cleaning method;

FIGs.12A-12B depict another exemplary wafer cleaning method;

FIGs.13A-13B depict another exemplary wafer cleaning method;

FIGs.14A-14B depict another exemplary wafer cleaning method;

FIGs.15A-15C depict a stable cavitation damaging patterned structure on a wafer during a cleaning process;

FIG.16 depicts another exemplary wafer cleaning apparatus using an ultra/mega sonic device; and

FIG.17 depicts an exemplary wafer cleaning apparatus using an ultra/mega sonic device;

FIGs.18A-18C depict another exemplary wafer cleaning method;

FIG.19 depicts another exemplary wafer cleaning method;

FIG.20A to FIG.20D depict bubbles in a status below the saturation point in the features of vias or trenches;

FIG.20E to FIG.20H depict the size of bubbles expanded by the ultra/mega sonic device to result in a ratio R of total bubbles volume $V_B$ to the volume of vias, trenches or recessed spaces $V_{VTR}$ being closed to or above the saturation point;

FIG.20I and FIG.20J depict the size of bubbles expanded by the ultra/mega sonic device within a limitation to result in the ratio R of total bubbles volume $V_B$ to the volume of vias, trenches or recessed spaces $V_{VTR}$ being much below the saturation point;

FIGs.21A-21D depict an exemplary substrate cleaning method;

FIGs.22A-22D depict another exemplary substrate cleaning method;

FIGs.23A-23C depict another exemplary substrate cleaning method.

DETAILED DESCRIPTION

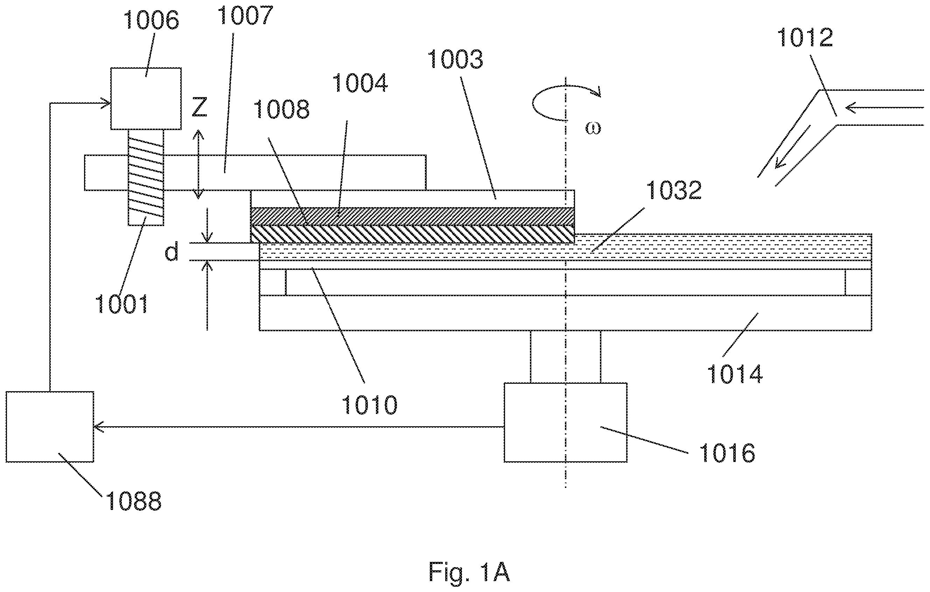

Figs. 1A to 1B show a wafer cleaning apparatus using an ultra/mega sonic device. The wafer cleaning apparatus consists of a wafer 1010, a wafer chuck 1014 being rotated by rotation driving mechanism 1016, a nozzle 1012 delivering cleaning chemicals or de-ionized water 1032, and an ultra/mega sonic device 1003 and an ultra/mega sonic power supply. The ultra/mega sonic device 1003 further consists of a piezoelectric transducer 1004 acoustically coupled to a resonator 1008. Transducer 1004 is electrically excited such that it vibrates and resonator 1008 transmits high frequency sound energy into liquid. The bubble cavitation generated by the ultra/mega sonic energy oscillates particles on wafer 1010. Contaminants are thus vibrated away from the surfaces of the wafer 1010, and removed from the surfaces through the flowing liquid 1032 supplied by nozzle 1012.

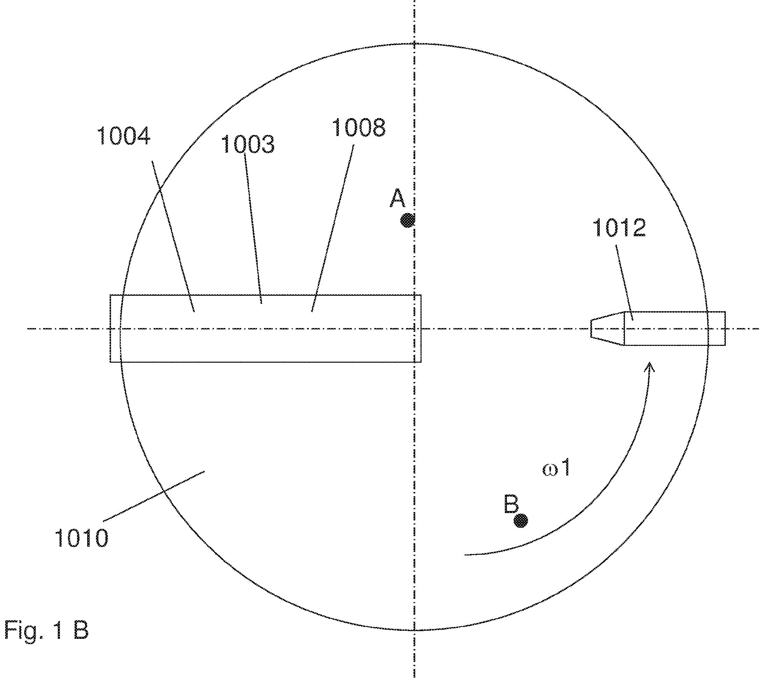

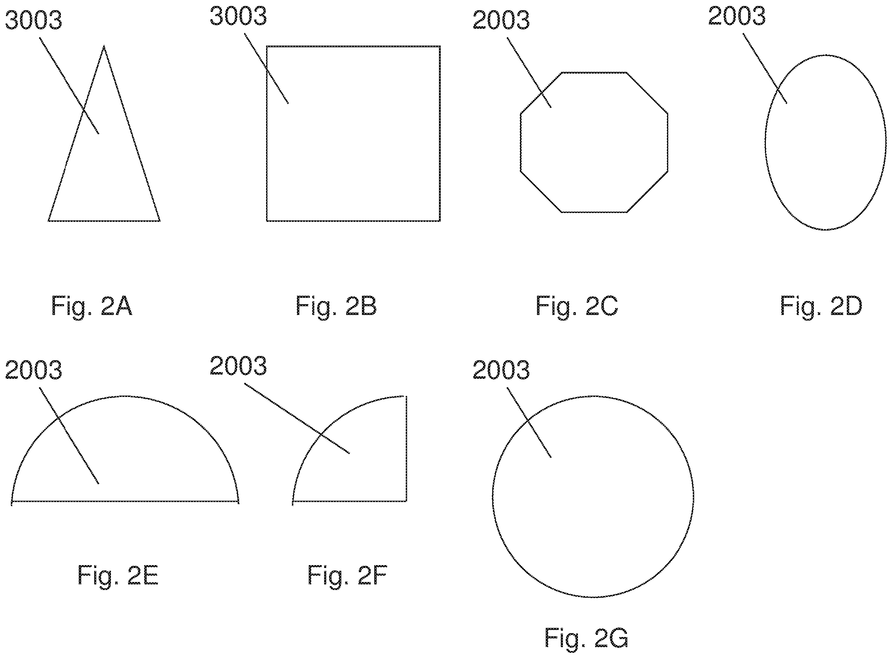

Figs. 2A to 2G show top view of ultra/mega sonic devices according to the present invention. Ultra/mega sonic device 1003 shown in Fig.1 can be replaced by ultra/mega sonic devices 3003 having a different shape, i.e., a triangle or pie shape as shown in Fig, 2A, a rectangle as shown in Fig, 2B, an octagon as shown in Fig. 2C, an ellipse as shown in Fig. 2D, a half circle as shown in Fig. 2E, a quarter circle as shown in Fig. 2F, and a circle as shown in Fig. 2G.

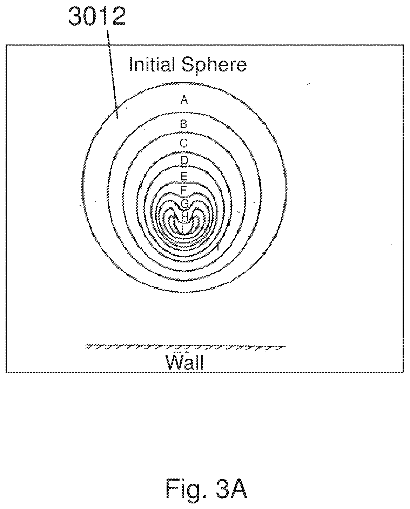

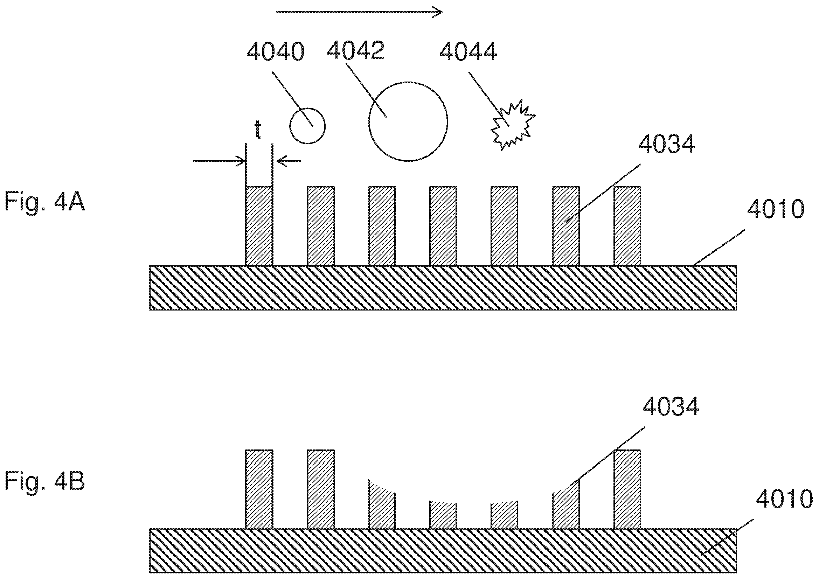

Fig. 3 shows a bubble cavitation during a compression phase. The shape of the bubble is gradually compressed from a spherical shape A to an apple shape G. Finally, the bubble reaches to an implosion status I and forms a micro jet. As shown in Fig.4A and 4B, the micro jet is very violent (can reach a few thousands atmospheric pressures and a few thousands $^0C$), which can damage the fine patterned structure 4034 on the semiconductor wafer 4010, especially when the feature size t shrinks to 70 nm and smaller.

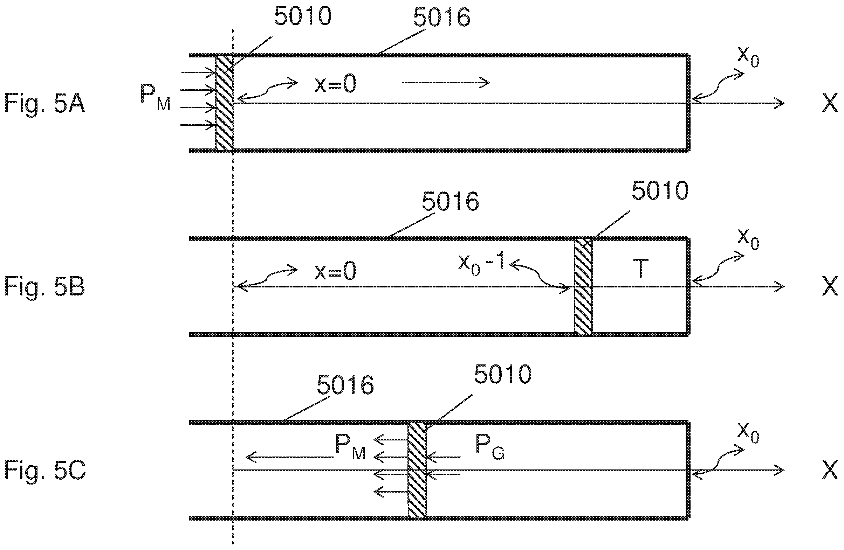

Figs. 5A to 5C show a simplified model of bubble cavitation according to the present invention. As sonic positive pressure acting on the bubble, the bubble reduces its volume. During this volume shrinking process, the sonic pressure $P_M$ did a work to the bubble, and the mechanical work converts to thermal energy inside the bubble, therefore temperature of gas and/or vapor inside the bubble increases.

The ideal gas equation can be expressed as follows:

$$p_0 v_0 / T_0 = pv / T \qquad (1),$$

where $p_0$ is pressure inside the bubble before compression, $v_0$ is initial volume of the bubble before compression, $T_0$ is temperature of gas inside the bubble before compression, p is pressure inside the bubble in compression, v is volume of the bubble in compression, T is temperature of gas inside the bubble in compression.

In order to simplify the calculation, it is assumed that the temperature of gas does not change during the compression or compression is very slow and temperature increase is cancelled by liquid surrounding the bubble. Accordingly, the mechanical work $w_m$ did by sonic pressure $P_M$ during one time of bubble compression (from volume N unit to volume 1 unit or compression ratio = N) can be expressed as follows:

$$w_m = \int_0^{x_0-1} pSdx = \int_0^{x_0-1} (S(x_0 p_0)/(x_0-x))dx = Sx_0 p_0 \int_0^{x_0-1} dx/(x_0-x)$$

$$= - Sx_0 p_0 \ln(x_0-x) \Big|_0^{x_0-1} = Sx_0 p_0 \ln(x_0) \tag{2}$$

where S is area of cross section of cylinder, $x_0$ is the length of the cylinder, $p_0$ is pressure of gas inside the cylinder before compression. Equation (2) does not consider the factor of temperature increase during the compression, so that the actual pressure inside the bubble will be higher due to temperature increase. Therefore, the actual mechanical work conducted by sonic pressure will be larger than that calculated by equation (2).

Assuming that all mechanical work made by sonic pressure is partially converted to thermal energy and partially converted to mechanical energy of high pressure gas and vapor inside the bubble, and such thermal energy fully contributes to temperature increase of gas inside of the bubble (no energy transferred to liquid molecules surrounding the bubble), and assuming that the mass of gas inside the bubble remains constant before and after compression, then temperature increase $\Delta T$ after one time of compression of the bubble can be expressed by the following formula:

$$\Delta T = Q/(mc) = \beta w_m /(mc) = \beta Sx_0 p_0 \ln(x_0)/(mc) \tag{3}$$

where Q is thermal energy converted from mechanical work, $\beta$ is ratio of thermal energy to total mechanical works made by sonic pressure, m is mass of gas inside the bubble, c is gas specific heat coefficient. Substituting $\beta= 0.65$, $S=1E-12\ m^2$, $x_0=1000\ \mu m=1E-3\ m$ (compression ratio N = 1000), $p_0=1\ kg/cm^2= 1E4\ kg/m^2$, m =8.9E-17 kg for hydrogen gas, c = 9.9E3 J/(kg $^0$K) into equation (3), then $\Delta T = 50.9\ ^0$K.

The temperature $T_1$ of gas inside the bubble after first time compression can be calculated as

$$T_1 = T_0 + \Delta T = 20\ ^0C + 50.9\ ^0C = 70.9\ ^0C \tag{4}$$

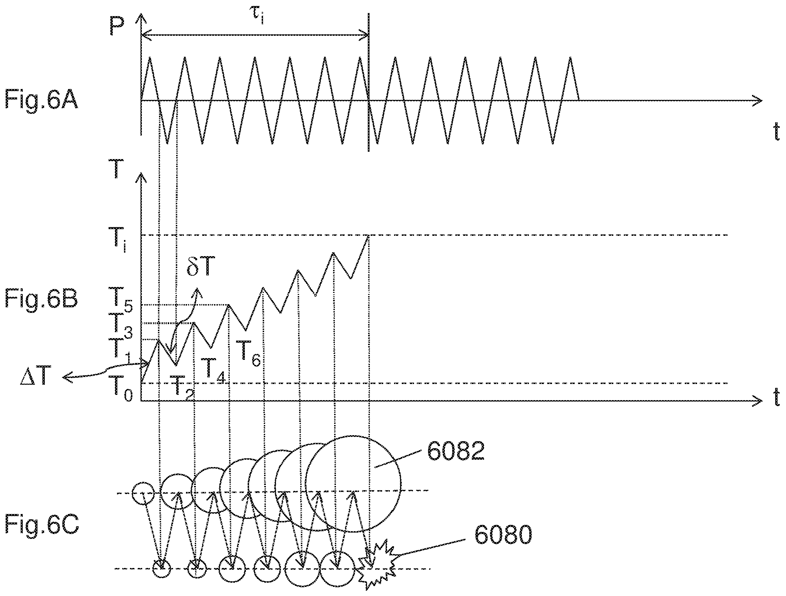

when the bubble reaches the minimum size of 1 micron as shown in Fig.5B. At such a high temperature, of course some liquid molecules surrounding bubble will evaporate. After that, the sonic pressure becomes negative and the bubble starts to increase its size. In this reverse process, the hot gas and vapor with pressure $P_G$ will do work to the surrounding liquid surface. At the same time, the sonic pressure $P_M$ is pulling the bubble to expansion direction as shown in Fig.5C, therefore the negative sonic pressure $P_M$ also does partial work to the surrounding liquid too. As a result of the joint efforts, the thermal energy inside the bubble cannot be fully released or converted to mechanical energy, therefore the temperature of gas inside the bubble cannot cool down to original gas temperature $T_0$ or the liquid temperature. After the first cycle of cavitation finishes, the temperature $T_2$ of gas in the bubble will be somewhere between $T_0$ and $T_1$ as shown in Fig.6B. Or $T_2$ can be expressed as

$$T_2 = T1 - \delta T = T_0 + \Delta T - \delta T \tag{5}$$

where $\delta T$ is temperature decrease after one time of expansion of the bubble, and $\delta T$ is smaller than $\Delta T$.

When the second cycle of bubble cavitation reaches the minimum bubble size, the temperature T3 of gas and or vapor inside the bubble will be T3 = T2 + $\Delta T$ =$T_0$ + $\Delta T$ - $\delta T$ + $\Delta T$ = $T_0$ + 2$\Delta T$ - $\delta T$ (6)

When the second cycle of bubble cavitation finishes, the temperature T4 of gas and/or vapor inside the bubble will be

$$T4 = T3 - \delta T = T_0 + 2\Delta T - \delta T - \delta T = T_0 + 2\Delta T - 2\delta T \tag{7}$$

Similarly, when the nth cycle of bubble cavitation reaches the minimum bubble size, the temperature $T_{2n-1}$ of gas and or vapor inside the bubble will be

$$T_{2n-1} = T_0 + n\Delta T - (n-1)\delta T \tag{8}$$

When the nth cycle of bubble cavitation finishes, the temperature $T_{2n}$ of gas and/or vapor inside the bubble will be

$$T_{2n} = T_0 + n\Delta T - n\delta T = T_0 + n(\Delta T - \delta T) \tag{9}$$

As cycle number n of bubble cavitation increases, the temperature of gas and vapor will increase, therefore more molecules on the bubble surface will evaporate into inside of bubble 6082 and size of bubble 6082 will increase too, as shown in Fig.6C. Finally the temperature inside the bubble during compression will reach implosion temperature $T_i$ (normally $T_i$ is as high as a few thousands $^0C$), and violent micro jet 6080 forms as shown in Fig.6C.

From equation (8), implosion cycle number $n_i$ can be written as follows:

$$n_i = (T_i - T_0 - \Delta T)/(\Delta T - \delta T) + 1 \qquad (10)$$

From equation (10), implosion time $\tau_i$ can be written as follows:

$$\tau_i = n_i t_1 = t_1((T_i - T_0 - \Delta T)/(\Delta T - \delta T) + 1)$$

$$= n_i/f_1 = ((T_i - T_0 - \Delta T)/(\Delta T - \delta T) + 1)/f_1$$

$$(11)$$

where $t_1$ is cycle period, and $f_1$ is frequency of ultra/mega sonic wave.

According to formulas (10) and (11), implosion cycle number $n_i$ and implosion time $\tau_i$ can be calculated. Table 1 shows calculated relationships among implosion cycle number $n_i$, implosion time $\tau_i$ and $(\Delta T - \delta T)$, assuming Ti = 3000 $^0C$, $\Delta T$ =50.9 $^0C$, $T_0$= 20 $^0C$, $f_1$ = 500 KHz, $f_1$ = 1 MHz, and $f_1$ = 2 MHz.

Table 1

| $\Delta T - \delta T$ ($^0C$) | 0.1 | 1 | 10 | 30 | 50 |
|---|---|---|---|---|---|
| $n_i$ | 29018 | 2903 | 291 | 98 | 59 |
| $\tau_i$(ms) $f_1$ =500 KHz | 58.036 | 5.806 | 0.582 | 0.196 | 0.118 |
| $\tau_i$(ms) $f_1$ =1 MHz | 29.018 | 2.903 | 0.291 | 0.098 | 0.059 |
| $\tau_i$(ms) $f_1$ =2 MHz | 14.509 | 1.451 | 0.145 | 0.049 | 0.029 |

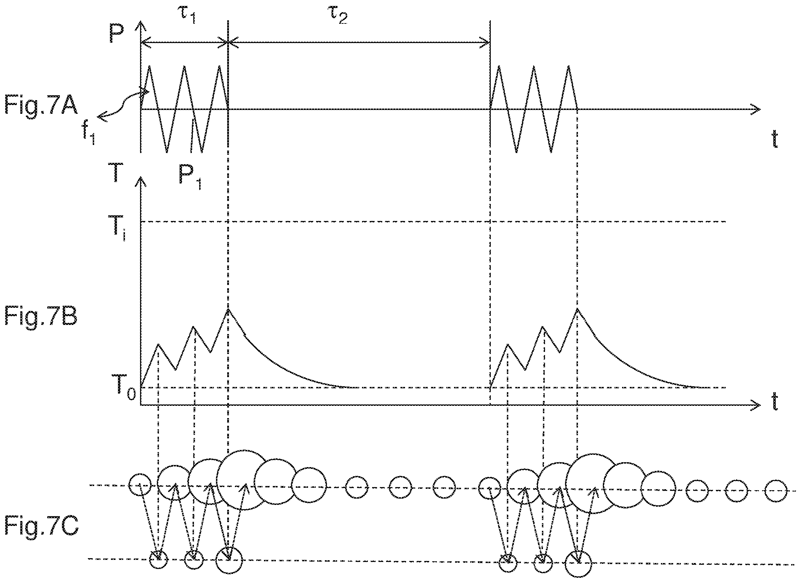

In order to avoid damage to the patterned structure on wafer, a stable cavitation must be maintained, and the bubble implosion or micro jet must be avoided. Figs.7A to 7C show a method to achieve a damage free ultra or mega-sonic cleaning on a wafer with a patterned structure by maintaining a stable bubble cavitation according to the present invention. Fig.7A shows waveform of power supply outputs, and Fig.7B shows the temperature curve corresponding to each cycle of cavitation, and Fig. 7C shows the bubble size expansion during each cycle of cavitation. Operation process steps to avoid bubble implosion according to the present invention are disclosed as follows:

Step 1: Put ultra/mega sonic device adjacent to surface of wafer or substrate set on a chuck or tank;
Step 2: Fill chemical liquid or gas (hydrogen, nitrogen, oxygen, or $CO_2$) doped water between wafer and the ultra/mega sonic device;
Step 3: Rotate chuck or oscillate wafer;
Step 4: Set power supply at frequency f1 and power $P_1$;
Step 5: Before temperature of gas and vapor inside the bubble reaches implosion temperature $T_i$, (or time reach $\tau_1 < \tau_i$ as being calculated by equation (11)), set power supply output to zero watts, therefore the temperature of gas inside the bubble start to cool down since the temperature of liquid or water is much lower than gas temperature;
Step 6: After temperature of gas inside the bubble decreases to room temperature $T_0$ or time (zero power time) reaches $\tau_2$, set power supply at frequency $f_1$ and power $P_1$ again; Step 7: repeat Step 1 to Step 6 until wafer is cleaned.

In step 5, time $\tau_1$ must be shorter than $\tau_i$ in order to avoid bubble implosion, and $\tau_i$ can be calculated by using equation (11).

In step 6, the temperature of gas inside the bubble is not necessarily cooled down to room temperature or liquid temperature; it can be certain a temperature above room temperature or liquid temperature, but better significantly lower than implosion temperature $T_i$.

According to equations 8 and 9, if $(\Delta T - \delta T)$ can be known, $\tau_i$ can be calculated. But in general, $(\Delta T - \delta T)$ is not easy

to be calculated or measured directly. The following method can determine the implosion time $\tau_i$ experimentally.

Step 1: Based on Table 1, choosing 5 different time $\tau_1$ as design of experiment (DOE) conditions;
Step 2: choose time $\tau_2$ at least 10 times $\tau_1$, better 100 times $\tau_1$ at the first screen test;
Step 3: fix certain power $P_0$ to run above five conditions cleaning on specific patterned structure wafer separately. Here, $P_0$ is the power at which the patterned structures on wafer will be surely damaged when running on continuous mode (non-pulse mode);
Step 4: Inspect the damage status of above five wafers by SEMS or wafer pattern damage review tool such as AMAT SEM vision or Hitachi IS3000, and then the implosion time $\tau_i$ can be located in certain range.

Steps 1 to 4 can be repeated again to narrow down the range of implosion time $\tau_i$. After knowing the implosion time $\tau_i$, time $\tau_1$ can be set at a value smaller than $0.5\tau i$ for safety margin. One example of experimental data is described as follows.

The patterned structures are 55 nm poly-silicon gate lines. Ultra/mega sonic wave frequency was 1 MHz, and ultra/mega-sonic device manufactured by Prosys was used and operated in a gap oscillation mode (disclosed by PCT/CN2008/073471) for achieving better uniform energy dose within wafer and wafer to wafer. Other experimental parameters and final pattern damage data are summarized in Table 2 as follows:

Table 2

| Wafer ID | $CO_2$ conc. (18 $\mu$s/cm) | Process Time (sec) | Power Density (Watts/cm2) | Cycle Number | $\tau_1$ (ms) | $\tau_2$ (ms) | Number of Damage Sites |
|---|---|---|---|---|---|---|---|
| #1 | 18 | 60 | 0.1 | 2000 | 2 | 18 | 1216 |
| #2 | 18 | 60 | 0.1 | 100 | 0.1 | 0.9 | 0 |

It was clear that the $\tau_1$ = 2 ms (or 2000 cycle number) introduced as many as 1216 damage sites to patterned structure with 55 nm feature size, but that the $\tau_1$ = 0.1 ms (or 100 cycle number) introduced zero (0) damage sites to patterned structure with 55 nm feature size. So that the $\tau_i$ is some number between 0.1 ms and 2 ms, more detailed tests need to be done to narrow its range. Obviously, the cycle number related to ultra or mega sonic power density and frequency, the larger the power density, the less the cycle number; and the lower the frequency, the less the cycle number. From the above experimental results, we can predict that the damage-free cycle number should be smaller than 2,000, assuming that the power density of ultra or mega sonic wave is larger than $0.1 wattsorcm^2$, and frequency of ultra or mega sonic wave is equal to or less than 1MHz. If the frequency increases to a range larger than 1 MHz or power density is less than 0. 1watts/cm$^2$, it can be predicted that the cycle number will increase.

After knowing time $\tau_1$, then time $\tau_2$ can be shortened based on similar DEO method described above, i.e. fix time $\tau_1$, gradually shorten time $\tau_2$ to run DOE until damage on patterned structure is observed. As time $\tau_2$ is shortened, the temperature of gas and or vapor inside the bubble cannot be cooled down enough, which will gradually shift average temperature of gas and vapor inside the bubble up, eventually it will trigger implosion of the bubble. This trigger time is called critical cooling time. After knowing critical cooling time $\tau_c$, time $\tau_2$ can be set at value larger than $2\tau_c$ for the same reason to gain safety margin.

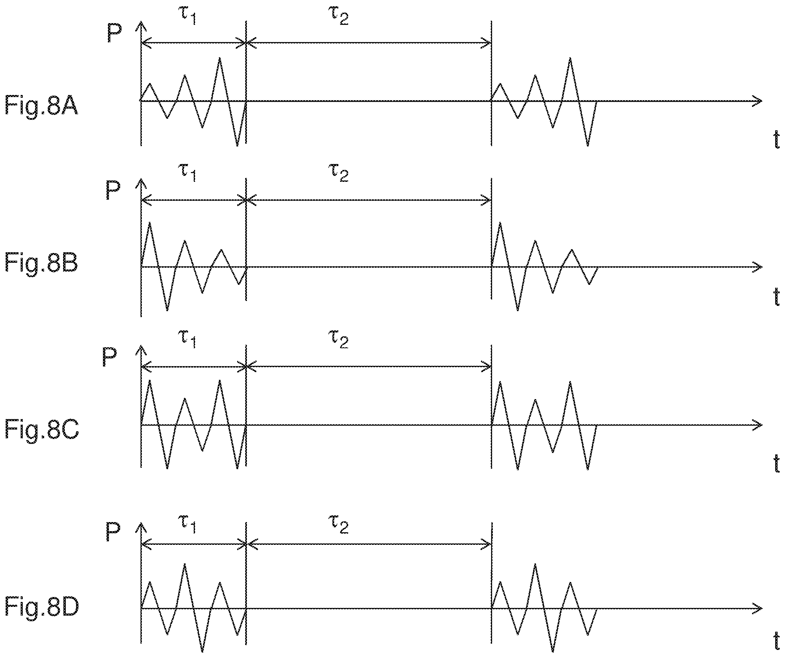

FIGs.8A to 8D show another embodiment of a wafer cleaning method using an ultra/mega sonic device according to the present invention. The method is similar to that shown in Fig. 7A, except in step 4 setting ultra/mega sonic power supply at frequency $f_1$ and power with changing amplitude of waveform. Fig. 8A shows another cleaning method of setting ultra/mega sonic power at frequency $f_1$ and power with increasing amplitude of waveform in step 4. Fig. 8B shows another cleaning method of setting ultra/mega sonic power supply at frequency $f_1$ and power with decreasing amplitude of waveform in step 4. Fig. 8C shows another cleaning method of setting ultra/mega sonic power supply at frequency $f_1$ and power with decreasing first and increasing later amplitude of waveform in step 4. Fig. 8D shows further another cleaning method of setting ultra/mega sonic power at frequency $f_1$ and power with increasing first and decreasing later amplitude of waveform in step 4.

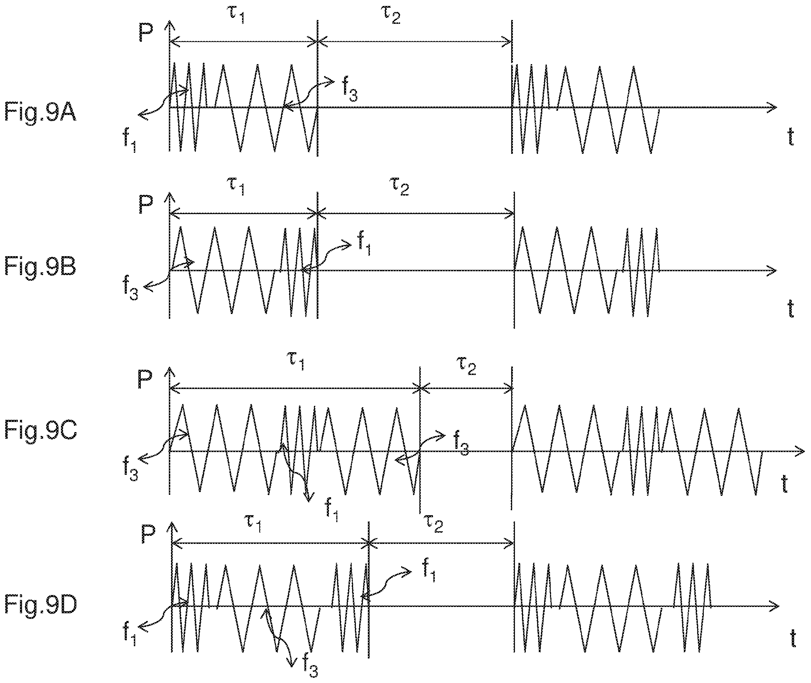

FIGs.9A to 9D show another embodiment of a wafer cleaning method using an ultra/mega sonic device according to the present invention. The method is similar to that shown in Fig. 7A, except in step 4 setting ultra/mega sonic power supply at changing frequency. Fig. 9A shows another cleaning method of setting ultra/mega sonic power supply at frequency $f_1$ first then frequency $f_3$ later, $f_1$ is higher than $f_3$ in step 4. Fig. 9B shows another cleaning method of setting ultra/mega sonic power supply at frequency $f_3$ first then frequency $f_1$ later, $f_1$ is higher than $f_3$ in step 4. Fig. 9C shows another cleaning method of setting ultra/mega sonic power supply at frequency $f_3$ first, frequency $f_1$ later and $f_3$ last, $f_1$ is higher than $f_3$ in step 4. Fig. 9D shows another cleaning method of setting ultra/mega sonic power supply at frequency $f_1$ first, frequency $f_3$ later and $f_1$ last, $f_1$ is higher than $f_3$ in step 4.

Similar to method shown in Fig. 9C, the ultra/mega sonic power can be set at frequency $f_1$ first, at frequency $f_3$ later and at frequency $f_4$ at last in step 4, where $f_4$ is smaller than $f_3$, and $f_3$ is smaller than $f_1$.

Again similar to method shown in Fig. 9C, the ultra/mega sonic power can be set at frequency $f_4$ first, at frequency $f_3$ later and at frequency $f_1$ at last in step 4, where $f_4$ is smaller than $f_3$, and $f_3$ is smaller than $f_1$

Again similar to method shown in Fig. 9C, the ultra/mega sonic power can be set at frequency $f_1$ first, at frequency $f_4$ later and at frequency $f_3$ at last in step 4, where $f_4$ is smaller than $f_3$, and $f_3$ is smaller than $f_1$.

Again similar to method shown in Fig. 9C, the ultra/mega sonic power can be set at frequency $f_3$ first, at frequency $f_4$ later and at frequency $f_1$ at last in step 4, where $f_4$ is smaller than $f_3$, and $f_3$ is smaller than $f_1$.

Again similar to method shown in Fig. 9C, the ultra/mega sonic power can be set at frequency $f_3$ first, at frequency $f_1$ later and at frequency $f_4$ at last in step 4, where $f_4$ is smaller than $f_3$, and $f_3$ is smaller than $f_1$.

Again similar to method shown in Fig. 9C, the ultra/mega sonic power can be set at frequency $f_4$ first, at frequency $f_1$ later and at frequency $f_3$ at last in step 4, where $f_4$ is smaller than $f_3$, and $f_3$ is smaller than $f_1$.

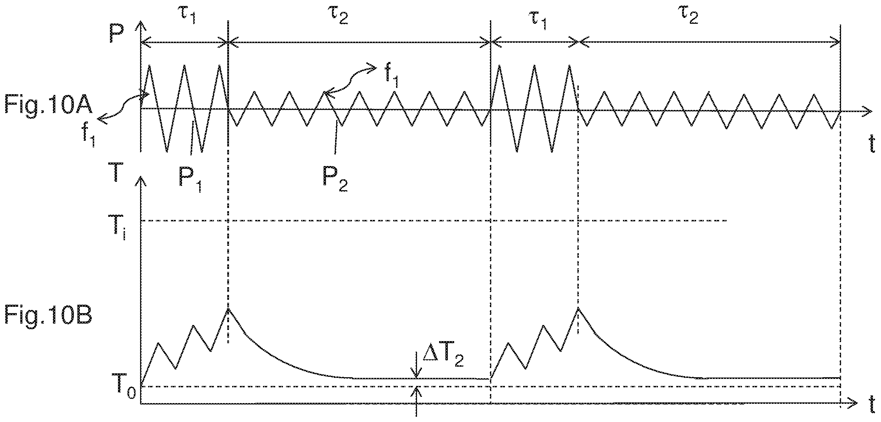

Figs. 10A to 10B show another method to achieve a damage free ultra/megasonic cleaning on a wafer with a patterned structure by maintaining a stable bubble cavitation in according to the present invention. Fig.10A shows waveform of power supply outputs, and Fig.10B shows the temperature curve corresponding to each cycle of cavitation. Operation process steps according to the present invention are disclosed as follows:

Step 1: Put ultra/mega sonic device adjacent to surface of wafer or substrate set on a chuck or tank;
Step 2: Fill chemical liquid or gas doped water between wafer and the ultra/mega sonic device;
Step 3: Rotate chuck or oscillate wafer;
Step 4: Set power supply at frequency $f_1$ and power $P_1$;
Step 5: Before temperature of gas and vapor inside the bubble reaches implosion temperature $T_i$, (total time $\tau_1$ elapses), set power supply output at frequency $f_1$ and power $P_2$, and $P_2$ is smaller than $P_1$. Therefore the temperature of gas inside the bubble start to cool down since the temperature of liquid or water is much lower than gas temperature;
Step 6: After temperature of gas inside the bubble decreases to certain temperature close to room temperature $T_0$ or time (zero power time) reach $\tau_2$, set power supply at frequency $f_1$ and power $P_1$ again;
Step 7: repeat Step 1 to Step 6 until wafer is cleaned.

In step 6, the temperature of gas inside the bubble cannot be cooled down to room temperature due to power $P_2$, there should be a temperature difference $\Delta T_2$ existing in later stage of $\tau_2$ time zone, as shown in Fig. 10B.

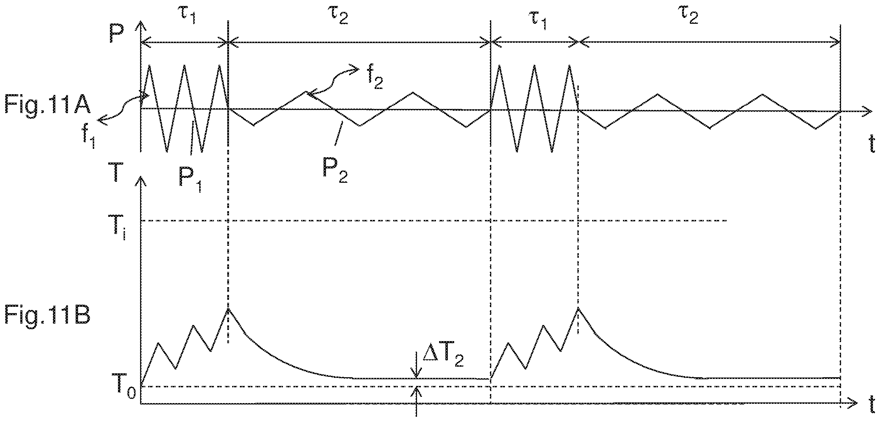

FIGs.11A to 11B show another embodiment of a wafer cleaning method using an ultra/mega sonic device according to the present invention. The method is similar to that shown in Fig. 10A, except in step 5 setting ultra/mega sonic power at frequency $f_2$ and power $P_2$, where $f_2$ is lower than $f_1$ and $P_2$ is less than $P_1$. Since $f_2$ is lower than $f_1$, the temperature of gas or vapor inside the bubble increases faster. Therefore, the P2 should be set significantly less than P1, better 5 or 10 times less in order to reduce temperature of gas and or vapor inside the bubble.

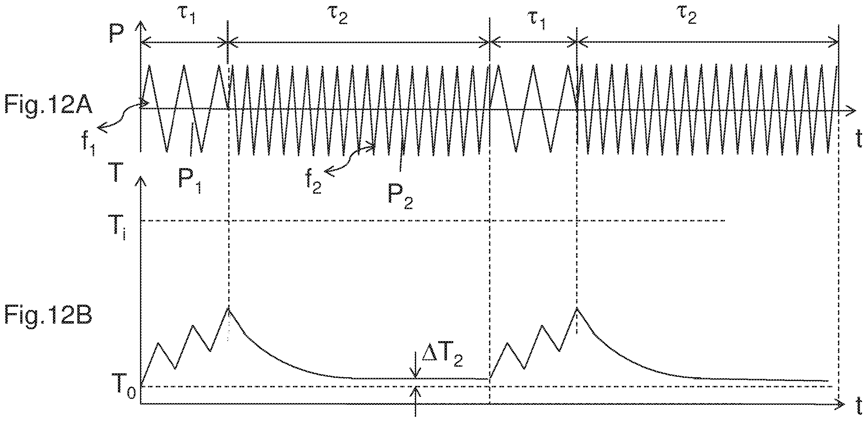

FIGs.12A to 12B show another embodiment of a wafer cleaning method using an ultra/mega sonic device according to the present invention. The method is similar to that shown in Fig. 10A, except in step 5 setting ultra/mega sonic power at frequency $f_2$ and power $P_2$, where $f_2$ is higher than $f_1$, and $P_2$ is equal to $P_1$.

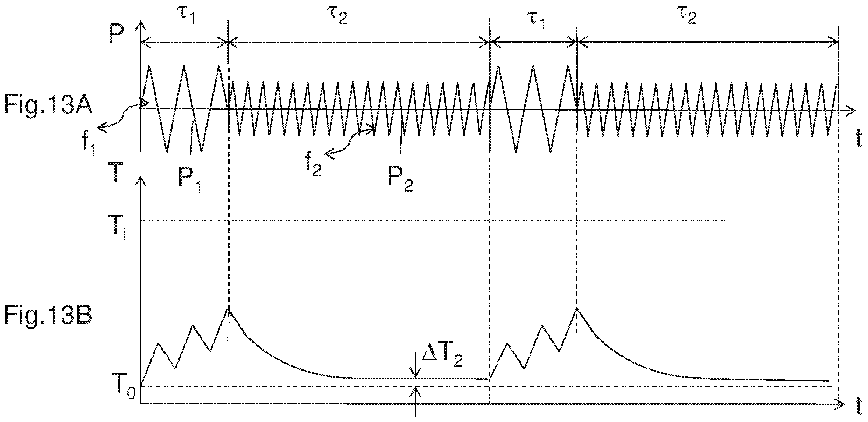

FIGs.13A to 13B show another embodiment of a wafer cleaning method using an ultra/mega sonic device according to the present invention. The method is similar to that shown in Fig. 10A, except in step 5 setting ultra/mega sonic power at frequency $f_2$ and power $P_2$, where $f_2$ is higher than $f_1$, and $P_2$ is less than $P_1$.

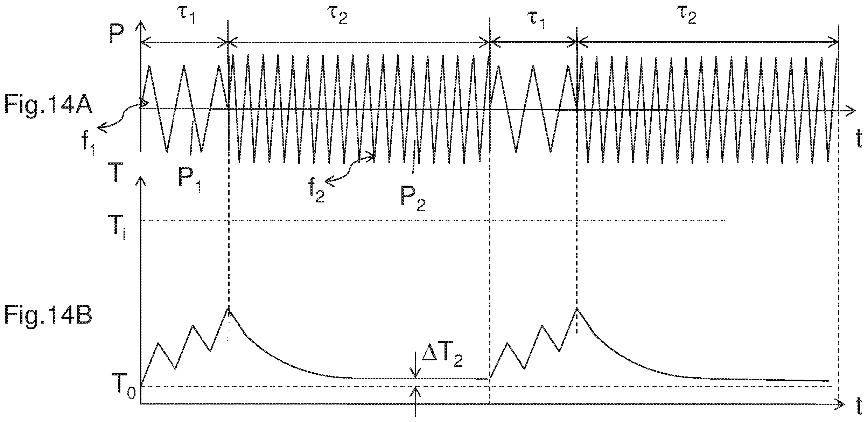

FIGs.14A-14B shows another embodiment of a wafer cleaning method using an ultra/mega sonic device according to the present invention. The method is similar to that shown in Fig. 10A, except in step 5 setting ultra/mega sonic power at frequency $f_2$ and power $P_2$, where $f_2$ is higher than $f_1$, and $P_2$ is higher than $P_1$. Since $f_2$ is higher than $f_1$, the temperature of gas or vapor inside the bubble increases slower. Therefore, the P2 can be slightly higher than P1, but must make sure the temperature of gas and vapor inside the bubble decreases in time zone $\tau_2$ comparing to temperature zone $\tau_1$, as shown in Fig.14B

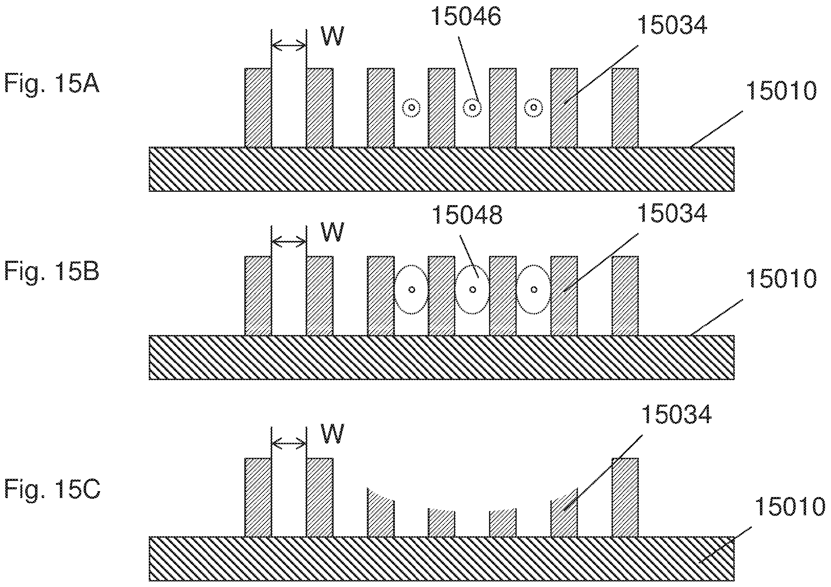

Fig.4A and 4B show that a patterned structure is damaged by the violent micro jet. Fig.15A and 15B show that the stable cavitation can also damage the patterned structure on wafer. As bubble cavitation continues, the temperature of gas and vapor inside the bubble increases, therefore the size of bubble 15046 also increases as shown in Fig.15A. When the size of bubble 15048 becomes larger than the dimension of space W in the patterned structure as shown in Fig.15B, the expansion force of bubble cavitation can damage the patterned structure 15034 as shown in Fig.15C. Another cleaning method according to the present invention is disclosed as follows:

Step 1: Put ultra/mega sonic device adjacent to surface of wafer or substrate set on a chuck or tank;
Step 2: Fill chemical liquid or gas doped water between wafer and the ultra/mega sonic device;
Step 3: Rotate chuck or oscillate wafer;
Step 4: Set power supply at frequency $f_1$ and power $P_1$;

Step 5: Before size of bubble reaches the same dimension of space W in patterned structures (time $\tau_1$ elapse), set power supply output to zero watts, therefore the temperature of gas inside the bubble starts to cool down since the temperature of liquid or water is much lower than gas temperature;

Step 6: After temperature of gas inside the bubble continues to reduce (either it reaches room temperature $T_0$ or time (zero power time) reach $\tau_2$, set power supply at frequency $f_1$ power $P_1$ again;

Step 7: repeat Step 1 to Step 6 until wafer is cleaned.

In step 6, the temperature of gas inside the bubble is not necessarily cooled down to room temperature, it can be any temperature, but better significantly lower than implosion temperature $T_i$. In step 5, bubble size can be slightly larger than dimension of patterned structures as long as bubble expansion force does not break or damage the patterned structure. Time $\tau_1$ can be determined experimentally by using the following method:

Step 1: Similar to Table 1, choosing 5 different time $\tau_1$ as design of experiment (DOE) conditions;

Step 2: choose time $\tau_2$ at least 10 times $\tau_1$, better 100 times $\tau_1$ at the first screen test;

Step 3: fix certain power $P_0$ to run above five conditions cleaning on specific patterned structure wafer separately. Here, $P_0$ is the power at which the patterned structures on wafer will be surely damaged when running on continuous mode (non-pulse mode);

Step 4: Inspect the damage status of above five wafers by SEMS or wafer pattern damage review tool such as AMAT SEM vision or Hitachi IS3000, and then the damage time $\tau_i$ can be located in certain range.

Steps 1 to 4 can be repeated again to narrow down the range of damage time $\tau_d$. After knowing the damage time $\tau_d$, time $\tau_1$ can be set at a value smaller than 0.5 $\tau_d$ for safety margin.

All cleaning methods described from Figs.7 to Figs.14 can be applied in or combined with the method described in Figs. 15.

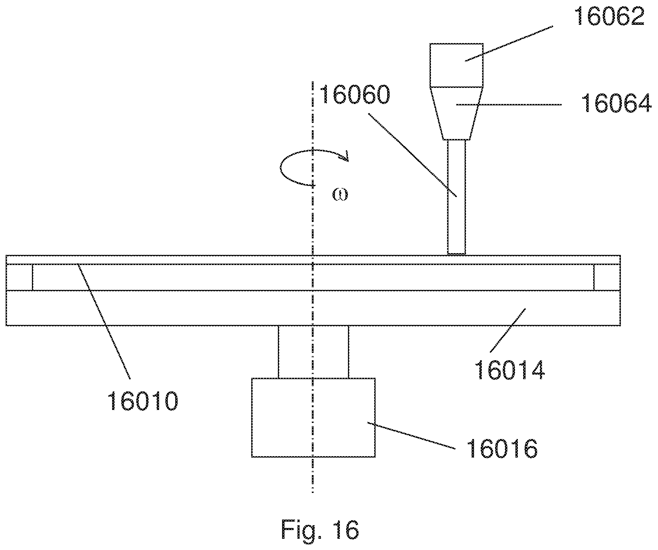

Fig. 16 shows a wafer cleaning apparatus using an ultra/mega sonic device. The wafer cleaning apparatus consists of wafer 16010, wafer chuck 16014 being rotated by rotation driving mechanism 16016, nozzle 16064 delivering cleaning chemicals or de-ionized water 16060, ultra/mega sonic device 16062 coupled with nozzle 16064, and ultra/mega sonic power supply. Ultra/mega sonic wave generated by ultra/mega sonic device 16062 is transferred to wafer through chemical or water liquid column 16060. All cleaning methods described from Figs.7 to Figs.15 can be used in cleaning apparatus described in Figs. 16.

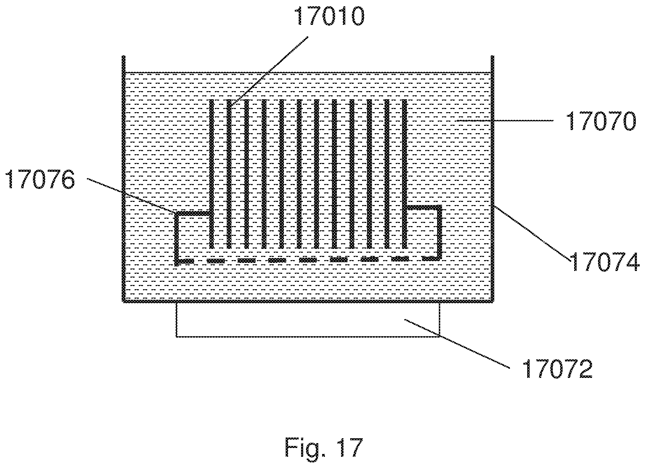

Fig. 17 shows a wafer cleaning apparatus using an ultra/mega sonic device. The wafer cleaning apparatus consists of wafers 17010, a cleaning tank 17074, a wafer cassette 17076 holding the wafers 17010 and being held in the cleaning tank 17074, cleaning chemicals 17070, an ultra/mega sonic device 17072 attached to outside wall of the cleaning tank 17074, and an ultra/mega sonic power supply. At least one inlet fills the cleaning chemicals 17070 into the cleaning tank 17074 to immerse the wafers 17010. All cleaning methods described from Figs.7 to Figs.15 can be used in cleaning apparatus described in Figs. 17.

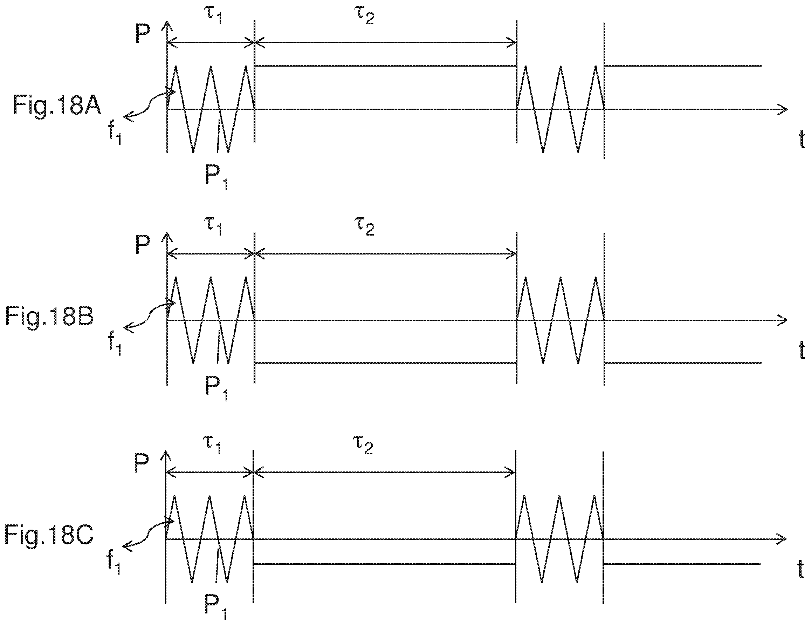

FIGs.18A to 18C show another embodiment of a wafer cleaning method using an ultra/mega sonic device according to the present invention. The method is similar to that shown in Fig. 7A, except in Step 5: before temperature of gas and vapor inside the bubble reaches implosion temperature $T_i$, (or time reach $\tau_1 < \tau_i$ as being calculated by equation (11)), set power supply output to a positive value or negative DC value to hold or stop ultra/mega sonic device to vibrate, therefore the temperature of gas inside the bubble start to cool down since the temperature of liquid or water is much lower than gas temperature. The positive value of negative value can be bigger, equal to or smaller than power $P_1$.

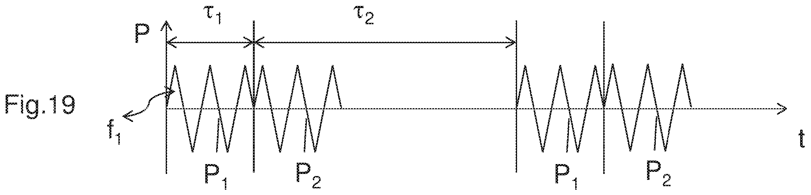

FIGs.19 shows another embodiment of a wafer cleaning method using an ultra/mega sonic device according to the present invention. The method is similar to that shown in Fig. 7A, except in Step 5: before temperature of gas and vapor inside the bubble reaches implosion temperature $T_i$, (or time reach $\tau_1 < \tau_i$ as being calculated by equation (11)), set power supply output at the frequency same as $f_1$ with reverse phase to $f_1$ to quickly stop the cavitation of bubble. Therefore the temperature of gas inside the bubble start to cool down since the temperature of liquid or water is much lower than gas temperature. The positive value of negative value can be bigger, equal or less than power $P_1$. During above operation, the power supply output can be set at a frequency different from frequency $f_1$ with reverse phase to $f_1$ in order to quickly stop the cavitation of bubble.

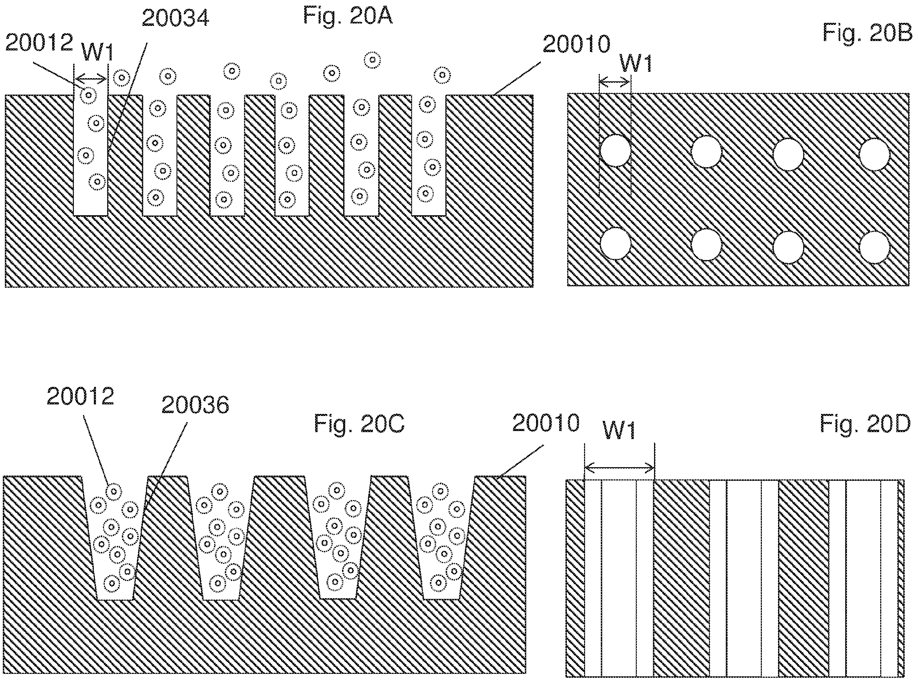

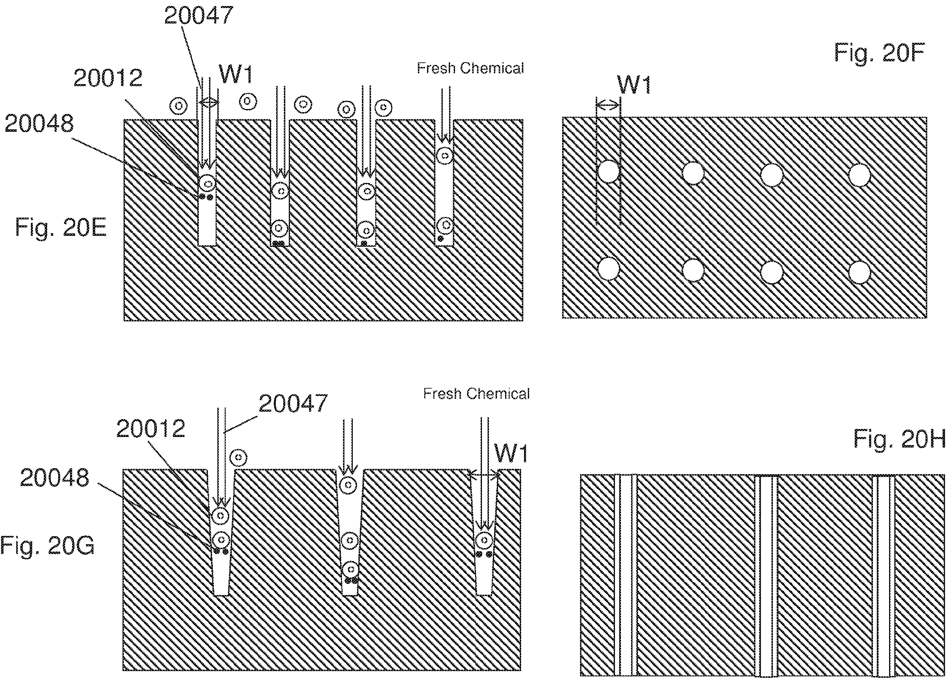

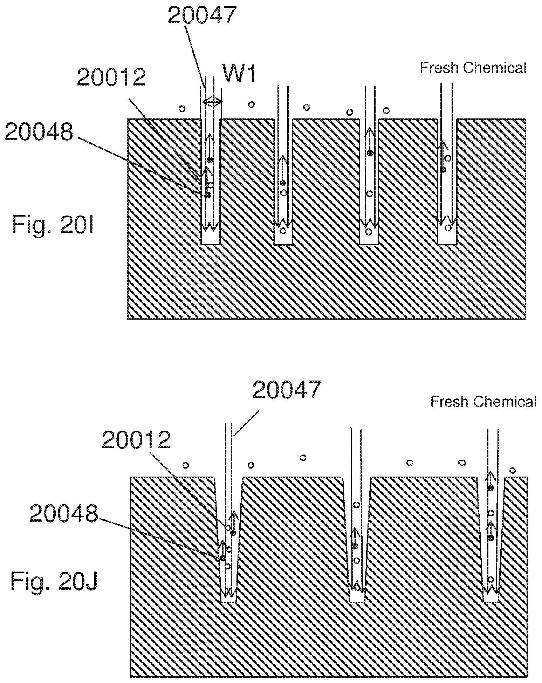

As shown in Fig.20A to Fig.20D, the bubbles 20012 are in a status below the saturation point in the feature of vias 20034 or trenches 20036 on a substrate 20010, so as to increase the fresh chemical exchange in the vias 20034 or trenches 20036 due to the bubble cavitation inside the features and also increase the removal of impurities such as residues and particles from the features. The saturation point $R_s$ is defined by the largest amount of bubbles inside the features of vias, trenches or recessed areas. Over the saturation point, the chemical liquid is blocked by the bubbles inside the feature and hardly reaches to the bottom or side walls of the features of vias and trenches, so that the cleaning performance of the chemical liquid is influenced. While below the saturation point, the chemical liquid has enough feasibility inside the features of vias or trenches, and a good cleaning performance is achieved.

Below the saturation point, the ratio R of total bubbles volume $V_B$ to the volume of vias or trenches, or recessed spaces $V_{VTR}$ is:

$$R=V_B/V_{VTR}< R_s$$

At or above the saturation point $R_s$, the ratio R of total bubbles volume $V_B$ to the volume of vias or trenches, or recessed spaces $V_{VTR}$ is:

$$R=V_B/V_{VTR}=R_s$$

The volume of the total bubbles in the features of vias, trenches or recessed space: $V_B = Nv_b$ where N is the total number of bubbles in the features and $v_b$ is an averaged single bubble volume.

As shown in Fig.20E to Fig.20H, the size of bubble 20012 expanded by the ultra/mega sonic device is gradually to a certain volume, which results in the ratio R of total bubbles volume $V_B$ to the volume of vias, trenches or recessed spaces $V_{VTR}$ is closed to or above the saturation point $R_s$. It leads to the expanded bubble 20012 blocking in the vias or trenches, where is the path of chemical exchanges and impurities removal. In the case, the megasonic power cannot thoroughly transfer into the vias or trenches to reach their bottom and sidewall, meanwhile, the particles, residues and other impurities 20048 trapped in the vias or trenches cannot go out efficiently. This case easily occurs as the critical dimension W1 decreasing smaller, and the bubbles in the features of vias and trenches intends to be saturated after being expanded.

As shown in Fig.20I to Fig.20J, the size of bubble 20012 is expanded by the ultra/mega sonic device within a limitation, and the ratio R of total bubbles volume $V_B$ to the volume of via, trench or recessed space $V_{VTR}$ is much below the saturation point. The fresh chemical 20047 exchanges freely in the vias or trenches due to the bubble cavitation inside the features to achieve a good cleaning performance, meanwhile, the impurities 20048 such as residues and particles go out of the features of vias, trenches and recessed space.

Since the total bubbles in the features is related to the number of bubbles and the bubble size in the features of vias and trenches, the control of bubble size expanded by the cavitation is critical for the cleaning performance in the high aspect ratio features cleaning process.

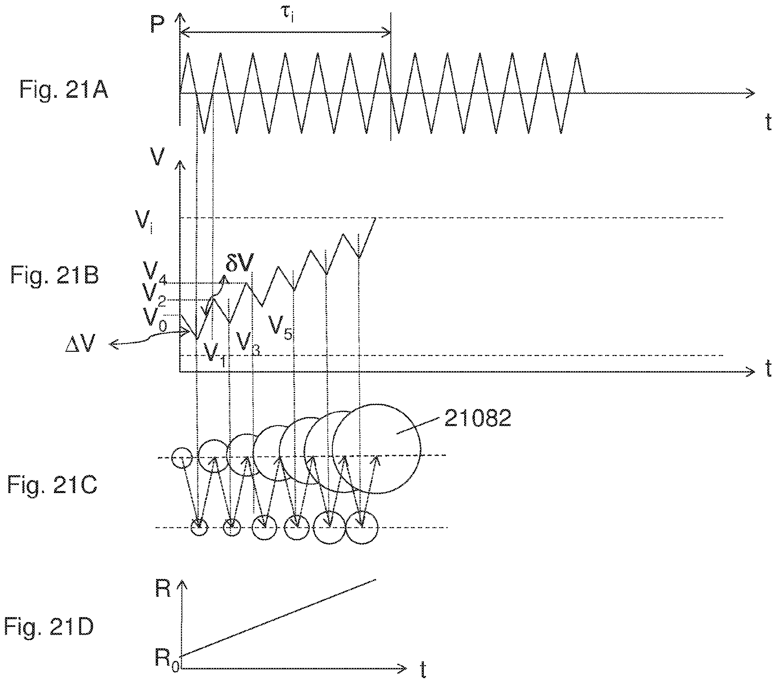

As shown in Fig. 21A to Fig. 21D, after the first cycle of cavitation finishes, the volume of $V_1$ of gas in bubble is compressed to a minimum size smaller than $V_0$ during positive sonic power working on it, and the volume of $V_2$ of gas in bubble will be returned back during the negative sonic power working on it. However, the temperature $T_2$ in the bubble with the volume of $V_2$ is higher than the temperature $T_0$ in the bubble with the volume of $V_0$ as shown in Fig. 21B, so that the volume of $V_2$ is bigger than the volume of $V_0$ due to some liquid molecules surrounding bubble will evaporate under the high temperature. And the volume of $V_3$ by the second compression of the bubble is somewhere between $V_1$ and $V_2$, as shown in Fig. 21B. And $V_1$, $V_2$ and $V_3$ can be expressed as

$$V_1= V_0-\Delta V \qquad\qquad (12)$$

$$V_2=V_1+\delta V \qquad\qquad (13)$$

$$V_3 = V_2 -\Delta V = V_1+\delta V-\Delta V=V_0-\Delta V+\delta V-\Delta V= V_0+\delta V-2\Delta V \qquad (14)$$

where $\Delta V$ is volume compression of bubble after one time of compression due to positive pressure generated by ultra/mega sonic wave, and $\delta V$ is volume increase of the bubble after one time of expansion due to negative pressure generated by ultra/mega sonic wave, and $\delta V -\Delta V$ is volume increase due to temperature increment $\Delta T - \delta T$ as calculated in equation (5) after one time cycle.

After the second cycle of bubble cavitation, the size of bubble reaches to the larger bubble size during the temperature keeping increasing, the volume of $V_4$ of gas and or vapor inside the bubble will be

$$V_4 = V_3 + \delta V = V_0+\delta V-2\Delta V+\delta V=V_0+2(\delta V-\Delta V) \qquad (15)$$

When the third cycle of bubble cavitation, the volume $V_5$ of gas and/or vapor inside the bubble will be

$$V_5 = V_4 - \Delta V = V_0 + 2(\delta V - \Delta V) - \Delta V = V_0 + 2\delta V - 3\Delta V \qquad (16)$$

Similarly, when the nth cycle of bubble cavitation reaches the minimum bubble size, the volume $V_{2n-1}$ of gas and or vapor inside the bubble will be

$$V_{2n-1} = V_0 + (n-1)\delta V - n\Delta V = V_0 + (n-1)\delta V - n\Delta V \qquad (17)$$

When the nth cycle of bubble cavitation finishes, the volume $V_{2n}$ of gas and/or vapor inside the bubble will be

$$V_{2n} = V_0 + n(\delta V - \Delta V) \qquad (18)$$

To restrict the volume of bubble into a desired volume $V_i$, which is a dimension with enough physical feasibility of movement or the bubbles status below the saturation point of cavitation or bubble density, rather than blocking the path of the chemical exchange in the features of vias, trenches or recessed areas, the cycle number $n_i$ can be written as follows:

$$n_i = (V_i - V_0 - \Delta V)/(\delta V - \Delta V) + 1 \qquad (19)$$

From equation (19), the desired time $\tau_i$ to achieve the $V_i$ can be written as follows:

$$\tau_i = n_i t_1 = t_1((V_i - V_0 - \Delta V)/(\delta V - \Delta V) + 1)$$
$$= n_i/f_1 = ((V_i - V_0 - \Delta T)/(\delta V - \Delta V) + 1)/f_1 \qquad (20)$$

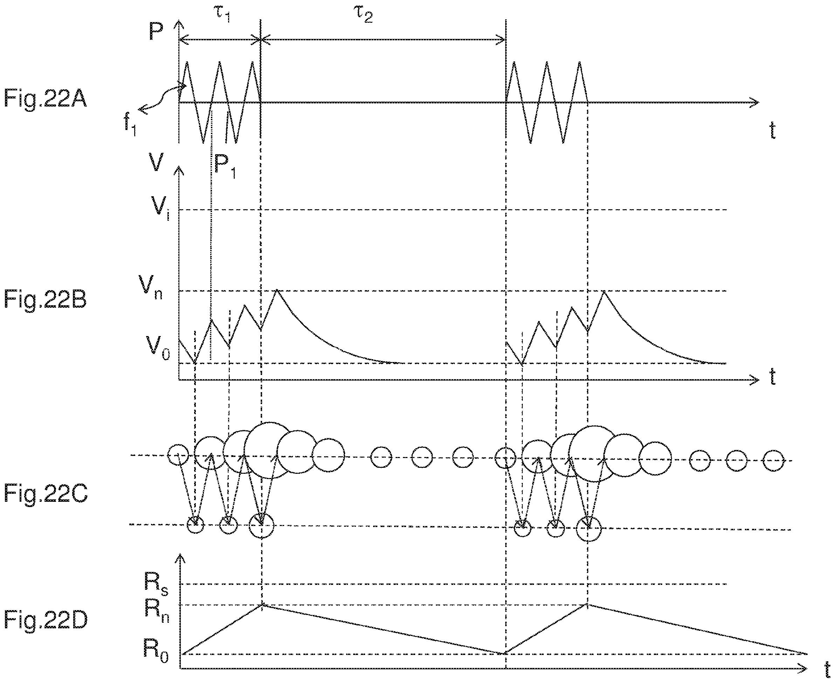

where $t_1$ is cycle period, and $f_1$ is frequency of ultra/mega sonic wave.
According to formulas (19) and (20), a desired cycle number $n_i$ and a time $\tau_i$ to restrict the bubble dimension can be calculated.
It should be pointed out that when the cycle number n of bubble cavitation increases, the temperature of gas and liquid (water) vapor inside the bubble will increase, therefore more molecules on bubble surface will evaporate into inside of bubble, therefore the size of bubble 21082 will further increase and be bigger than value calculated by equation (18). In practical operation, since the bubble size will be determined by experimental method to be disclosed later, therefore bubble size impacted by the evaporation of liquid or water for bubble inner surface due to temperature increase will not be theoretically discussed in detail here. As the average single bubble volume keeps increasing, the ratio R of total bubbles volume $V_B$ to the volume of via, trench or recessed space $V_{VTR}$ increases from $R_0$ continuously, as shown in Fig. 21D.
As the bubble volume increases, the diameter of bubble eventually will reach the same size or same order size of feature W1 such as via as shown in Fig. 20E and trench or recessed area as shown in Fig. 20G. Then the bubble inside via and trench will block ultra/mega sonic energy further get into the bottom of via and trench, especially when the aspect ratio (depth/width) is larger than 3 time or more. Therefore contaminations or particles at bottom of such deep via or trench cannot be effectively removed or cleaned.
In order to avoid the bubble growth up to a critical dimension to block the path of chemical exchanges in the features of vias or trenches, Figs.22A to 22D disclose a method to achieve an effective ultra/mega sonic cleaning on a substrate with high aspect ratio features of vias or trenches by maintaining a restricted size bubble cavitation according to the present invention. Fig.22A shows waveform of power supply outputs, and Fig.22B shows the bubble volume curve corresponding to each cycle of cavitation, and Fig. 22C shows the bubble size expansion during each cycle of cavitation, and Fig. 22D shows the curve of the ratio R of total bubbles volume $V_B$ to the volume of via, trench or recessed space $V_{VTR}$. According to

$$R = V_B/V_{VTR} = Nv_b/V_{VTR},$$

the ratio R of total bubbles volume $V_B$ to the volume of via, trench or recessed space $V_{VTR}$ increases from $R_0$ to $R_n$, where the average single bubble volume is expanded by the sonic cavitation after a certain cycle number n, in time $\tau_1$. And the $R_n$ is controlled below the saturation point $R_s$,

$$R_n = V_B/V_{VTR} = Nv_b/V_{VTR} < Rs.$$

The ratio R of total bubbles volume $V_B$ to the volume of via, trench or recessed space $V_{VTR}$ decreases from $R_n$ to $R_0$, where the average single bubble volume returns to original size in the cooling process in time $\tau_2$.

Operation process steps to avoid bubble size growth up according to the present invention are disclosed as follows:

Step 1: Put ultra/mega sonic device adjacent to surface of substrate or substrate set on a chuck or tank;

Step 2: Fill chemical liquid or gas (hydrogen, nitrogen, oxygen, or $CO_2$) doped water between substrate and the ultra/mega sonic device;

Step 3: Rotate chuck or oscillate substrate;

Step 4: Set power supply at frequency $f_1$ and power $P_1$;

Step 5: After the volume of bubble expands to a certain volume $V_n$ or diameter w, (or time reach $\tau_1$), set power supply output to zero watts, therefore the volume of gas inside the bubble start to shrink down since the temperature of liquid or water cooling down the gas temperature;

Step 6: After the volume of bubble decreases to original volume while the gas temperature decreasing to room temperature $T_0$ or time (zero power time) reaches $\tau_2$, set power supply at frequency $f_1$ and power $P_1$ again;

Step 7: repeat Step 1 to Step 6 until substrate is cleaned.

In step 5, the expanded bubble's volume of $V_n$ or diameter w is not necessary to be restricted to be smaller than the dimension $V_i$ or feature size w1 that blocking the features of vias or trenches. It can be certain volume above the $V_i$, but better smaller than the dimension $V_i$ in order to obtain an effective cleaning with shortest process time. And the $\tau_1$ is also not necessary to be restricted to be smaller than $\tau_i$, but better smaller than the $T_i$ as being defined in the equation (20).

In step 6, the volume of bubble is not necessary to shrink down to an original volume. It can be certain volume above original volume, but better significantly smaller than the $V_i$ to restrict bubble size to get ultra/mega sonic power to be transmitted to the bottom of features such as via, trench, or recessed area.

Fig.22B shows that the bubble is expanded into a big volume $V_n$ by the ultra/mega sonic power working on it during a time $\tau_1$. At this state, the path of mass transfer is partially blocked. And then the fresh chemical cannot thoroughly transfer into the vias or trenches to reach their bottom and sidewall, meanwhile, the particles, residues and other impurities trapped in the vias or trenches cannot go out efficiently. But the state will alternate into the next state for bubble shrinking: when the ultra/mega sonic power is off for cooling the bubble during a time $\tau_2$ as shown in Fig.22A. In this cooling state, the fresh chemical has chance to transfer into the vias or trenches so as to clean their bottom and sidewall. When the ultra/mega sonic power is on in the next on cycle, the particles, residues and other impurities can be removed out of the vias or trenches by pull out force generated by bubble volume increment. If the two states are alternating in a cleaning process, it achieves a performance of an effective ultra/mega sonic cleaning on a substrate with high aspect ratio features of vias or trenches or recessed areas.

The cooling state in time $\tau_2$ plays a key role in this cleaning process. It should be defined precisely. Time $\tau_1 < \tau_i$, to restrict bubble size is desired, and the definition of $\tau_i$ also is preferred. The following method can determine time $\tau_2$ to shrink bubble size during a cooling down state and time $\tau_1$ to restrict the bubble expanded to the blockage size experimentally. The experiment is done by using an ultra/mega sonic device coupling with a chemical liquid to clean a pattern substrate with small features of vias and trenches, where the traceable residues exist to evaluate the cleaning performance.

Step 1: choose a $\tau_1$ which is big enough to block the features, which can be calculation as $\tau_i$ based on the equation (20).

Step 2: choose different time $\tau_2$ to run DOE. The selection of time $\tau_2$ is at least 10 times $\tau_1$, better 100 times $\tau_1$ at the first screen test.

Step 3: Fix time $\tau_1$ and fix certain power $P_0$ to run at least five conditions cleaning on specific patterned structure substrate separately. Here, $P_0$ is the power at which the features of vias or trenches on substrate will be surely not cleaned when running on continuous mode (non-pulse mode).

Step 4: Inspect the traceable residues status inside the features of vias or trenches of above five substrates by SEMS or element analyzer tool such as EDX.

Step 1 to step 4 can be repeated again to gradually shorten time $\tau_2$ until the traceable residues inside the features of vias or trenches are observed. As time $\tau_2$ is shortened, the volume of bubble cannot shrink down enough, which will gradually block the features and influence the cleaning performance. This time is called critical cooling time $\tau_c$. After knowing critical cooling time $\tau_c$, time $\tau_2$ can be set at value larger than $2\tau_c$ to gain safety margin.

A more detailed example is shown as follows:

Step 1: choosing 10 different times $\tau_1$ as design of experiment (DOE) conditions, such as $\tau_{10}$, $2\tau_{10}$, $4\tau_{10}$, $8\tau_{10}$, $16\tau_{10}$, $32\tau_{10}$, $64\tau_{10}$, $128\tau_{10}$, $256\tau_{10}$, $512\tau_{10}$, as shown in Table 3;

Step 2: choosing time $\tau_2$ at least 10 times $512\tau_{10}$, better 20 times $512\tau_{10}$ at the first screen test, as shown in Table 3;

Step 3: fixing certain power $P_0$ to run above ten conditions cleaning on specific patterned structure substrate separately. Here, $P_0$ is the power at which the features of vias or trenches on substrate will be surely not cleaned when running on continuous mode (non-pulse mode).

Table 3

| Substrate# | 1 | 2 | 3 | 4 | 5 | 6 | 7 | 8 | 9 | 10 |
|---|---|---|---|---|---|---|---|---|---|---|
| $\tau_1$ | $\tau_{10}$ | $2\tau_{10}$ | $4\tau_{10}$ | $8\tau_{10}$ | $16\tau_{10}$ | $32\tau_{10}$ | $64\tau_{10}$ | $128\tau_{10}$ | $256\tau_{10}$ | $512\tau_{10}$ |
| $T_2$ | $5120\tau_{10}$ | $5120\tau_{10}$ | $5120\tau_{10}$ | $5120\tau_{10}$ | $5120\tau_{10}$ | $5120\tau_{10}$ | $5120\tau_{10}$ | $5120\tau_{10}$ | $5120\tau_{10}$ | $5120\tau_{10}$ |
| Power | P0 | P0 | P0 | P0 | P0 | P0 | P0 | P0 | P0 | P0 |
| Process Time | $T_0$ | $T_0$ | $T_0$ | $T_0$ | $T_0$ | $T_0$ | $T_0$ | $T_0$ | $T_0$ | $T_0$ |
| Clean Status of Features | 1 | 2 | 3 | 4 | 5 | 6 | 5 | 4 | 4 | 3 |

Step 4: Using above conditions as shown in Table 3 to process 10 substrates with features of vias or trenches post plasma etching. The reason to choose the post plasma etched substrate is that the polymers generated during etching process are formed on sidewalls of trenches and vias. Those polymers formed on the bottom or side wall of via are difficulty to remove by a conventional method. Then inspect the cleaning status of features of vias or trenches on the ten substrates by SEMS with crossing section of substrates. The data are shown in Table 3. From Table 3, the cleaning effect reaches the best point of 6 at $\tau_1 = 32\tau_{10}$, therefore the optimum time $\tau_1$ is $32\tau_{10}$.

If there is no peak to be found, then step 1 to step 4 with board time setting of $\tau_1$ can be repeated again to find time $\tau_1$. After find the initial $\tau_1$, then step 1 to step 4 with time setting close to $\tau_1$ can be repeated again to narrow down the range of time $\tau_1$. After knowing time $\tau_i$, time $\tau_2$ can be optimized by reducing time $\tau_2$ from $512\tau_2$ to a value until the cleaning effect is reduced. A detailed procedure is disclosed as follows Table 4:

Table 4

| Substrate# | 1 | 2 | 3 | 4 | 5 | 6 | 7 | 8 |
|---|---|---|---|---|---|---|---|---|
| $\tau_1$ | $32\tau_{10}$ | $32\tau_{10}$ | $32\tau_{10}$ | $32\tau_{10}$ | $32\tau_{10}$ | $32\tau_{10}$ | $32\tau_{10}$ | $32\tau_{10}$ |
| $\tau_2$ | $4096\tau_{10}$ | $2048\tau_{10}$ | $1024\tau_{10}$ | $512\tau_{10}$ | $256\tau_{10}$ | $128\tau_{10}$ | $64\tau_{10}$ | $32\tau_{10}$ |
| Power | P0 | P0 | P0 | P0 | P0 | P0 | P0 | P0 |
| Process Time | $T_0$ | $T_0$ | $T_0$ | $T_0$ | $T_0$ | $T_0$ | $T_0$ | $T_0$ |
| Clean Status of Features | 3 | 4 | 5 | 6 | 7 | 6 | 5 | 3 |

From Table 4, the cleaning effect reaches the best point of 7 at $\tau_2 = 256\tau_{10}$, therefore the optimum time $\tau_2$ is $256\tau_{10}$.

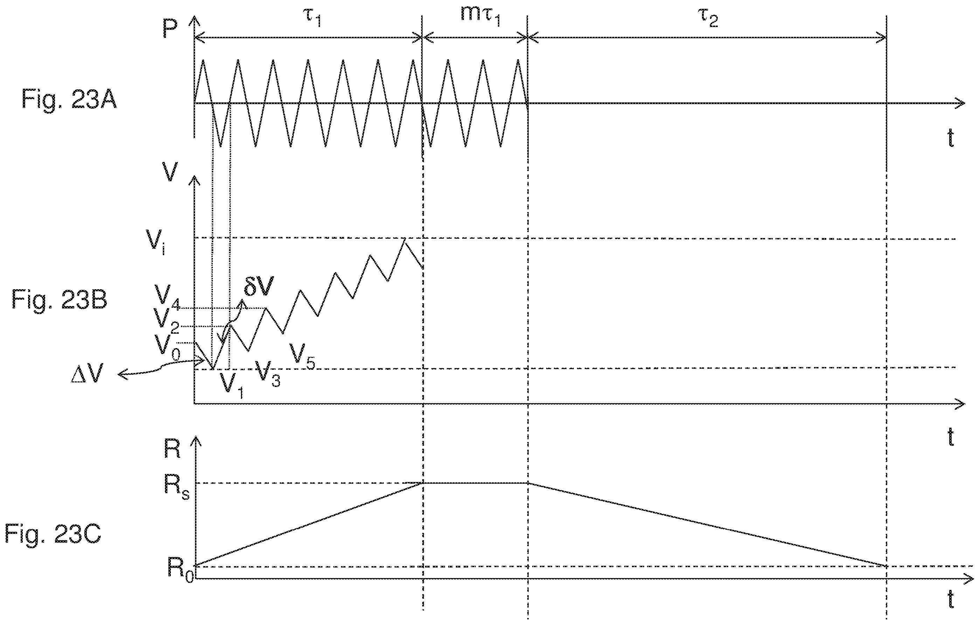

FIGs.23A to 23C show another embodiment of substrate cleaning method using an ultra/mega sonic device according to the present invention. The method is similar to that shown in Figs. 22A to 22D, except that power is still on for period of $m\tau_1$ even the cavitation reaches a saturation point Rs. Here, m can be number from 0.1 to 100, preferably 2, which is depending on via and trench structure and chemicals, and it need to be optimized by experiment explained in embodiment as Figs. 22A to 22D.

The method and apparatus disclosed in Fig. 8 to Fig.14, and Fig. 16 to Fig.19 can be applied in embodiments as shown in Fig. 22 and Fig.23, it will not be described here again.

Generally speaking, an ultra/mega sonic wave with the frequency between 0.1MHz~10MHz may be applied to the method disclosed in the present invention.

As described above, the present invention discloses a method for effectively cleaning vias, trenches or recessed areas on a substrate using an ultra/mega sonic device, comprising: applying liquid into a space between a substrate and an ultra/mega sonic device; setting an ultra/mega sonic power supply at frequency $f_1$ and power $P_1$ to drive said ultra/mega sonic device; after a ratio of total bubbles volume to volume inside vias, trenches or recessed areas on the substrate increases to a first set value, setting said ultra/mega sonic power supply at frequency $f_2$ and power $P_2$ to drive said ultra/mega sonic device; after the ratio of total bubbles volume to volume inside the vias, trenches or recessed areas reduces to a second set value, setting said ultra/mega sonic power supply at frequency $f_1$ and power $P_1$ again; repeating the above steps until the substrate is cleaned.

The first set value is below the cavitation saturation point. The second set value is much lower than the cavitation saturate point. The temperature inside the bubble cooling down results in the ratio of total bubbles volume to volume inside the vias, trenches or recessed areas reducing to the second set value. The temperature inside the bubble cooling down to near temperature of said liquid.

In the above embodiment, the first set value is a cavitation saturation point, and even after the ratio of total bubbles volume to volume inside vias, trenches or recessed areas on the substrate reaches the cavitation saturation point, the ultra/mega sonic power supply is still kept at frequency $f_1$ and power $P_1$ for a period of $m\tau_1$, where $\tau_1$ is the time to reach the cavitation saturation point, m is a multiple of $\tau_1$, and is a number between 0.1 to 100, preferably 2.

According to an embodiment, the present invention discloses an apparatus for effectively cleaning vias, trenches or recessed areas on a substrate using an ultra/mega sonic device. The apparatus includes a chuck, an ultra/mega sonic device, at least one nozzle, an ultra/mega sonic power supply and a controller. The chuck holds a substrate. The ultra/mega sonic device is positioned adjacent to the substrate. The at least one nozzle is configured to inject chemical liquid on the substrate and a gap between the substrate and the ultra/mega sonic device. The controller is configured to set the ultra/mega sonic power supply at frequency $f_1$ and power $P_1$ to drive the ultra/mega sonic device; after a ratio of total bubbles volume to volume inside vias, trenches or recessed areas on the substrate increases to a first set value, the controller is configured to set the ultra/mega sonic power supply at frequency $f_2$ and power $P_2$ to drive the ultra/mega sonic device; after the ratio of total bubbles volume to volume inside the vias, trenches or recessed areas reduces to a second set value, the controller is configured to set the ultra/mega sonic power supply at frequency $f_1$ and power $P_1$ again, and repeat

the above steps until the substrate is cleaned.

According to another embodiment, the present invention discloses an apparatus for effectively cleaning vias, trenches or recessed areas on a substrate using an ultra/mega sonic device. The apparatus includes a cassette, a tank, an ultra/mega sonic device, at least one inlet, an ultra/mega sonic power supply and a controller. The cassette holds at least one substrate. The tank holds the cassette. The ultra/mega sonic device is attached to outside wall of the tank. At least one inlet is used for filling chemical liquid into the tank to immerse the substrate. The controller is configured to set the ultra/mega sonic power supply at frequency $f_1$ and power $P_1$ to drive the ultra/mega sonic device; after a ratio of total bubbles volume to volume inside vias, trenches or recessed areas on the substrate increases to a first set value, the controller is configured to set the ultra/mega sonic power supply at frequency $f_2$ and power $P_2$ to drive the ultra/mega sonic device; after the ratio of total bubbles volume to volume inside the vias, trenches or recessed areas reduces to a second set value, the controller is configured to set the ultra/mega sonic power supply at frequency $f_1$ and power $P_1$ again, and repeat the above steps until the substrate is cleaned.

According to another embodiment, the present invention discloses an apparatus for effectively cleaning vias, trenches or recessed areas on a substrate using an ultra/mega sonic device. The apparatus includes a chuck, an ultra/mega sonic device, a nozzle, an ultra/mega sonic power supply and a controller. The chuck holds a substrate. The ultra/mega sonic device coupled with a nozzle is positioned adjacent to the substrate. The nozzle injects chemical liquid on the substrate. The controller is configured to set the ultra/mega sonic power supply at frequency $f_1$ and power $P_1$ to drive the ultra/mega sonic device; after a ratio of total bubbles volume to volume inside vias, trenches or recessed areas on the substrate increasing to a first set value, the controller is configured to set the ultra/mega sonic power supply at frequency $f_2$ and power $P_2$ to drive the ultra/mega sonic device; after the ratio of total bubbles volume to volume inside the vias, trenches or recessed areas reduces to a second set value, the controller is configured to set the ultra/mega sonic power supply at frequency $f_1$ and power $P_1$ again, and repeat the above steps until the substrate is cleaned.

Although the present invention has been described with respect to certain embodiments, examples, and applications, it will be apparent to those skilled in the art that various modifications and changes may be made without departing from the invention, which is defined by the appended claims.

**Claims**

1. A method for cleaning vias, trenches or recessed areas on a substrate using an ultra/mega sonic device, the method comprising:

   applying liquid (1032) into a space between a substrate and an ultra/mega sonic device (1003);
   the method further comprising:

   setting an ultra/mega sonic power supply at a first frequency ($f_1$) and a first power ($P_1$) to drive said ultra/mega sonic device (1003) during a first time interval;
   after a ratio (R) of total bubbles volume ($V_B$) to volume ($V_{VTR}$) inside vias (20034), trenches (20036) or recessed areas on the substrate increases to a first set value, setting said ultra/mega sonic power supply at a second frequency ($f_2$) and a second power ($P_2$) to drive said ultra/mega sonic device (1003) during a second time interval;
   after the ratio (R) of total bubbles volume ($V_B$) to volume ($V_{VTR}$) inside the vias (20034), trenches (20036) or recessed areas reduces to a second set value, setting said ultra/mega sonic power supply at the first frequency ($f_1$) and the first power ($P_1$) again; and
   repeating the above steps until the substrate is cleaned.

2. The method of claim 1, wherein the first time interval is determined to end when the ratio (R) of total bubbles volume ($V_B$) to volume ($V_{VTR}$) inside the vias (20034), trenches (20036) or recessed areas reaches a first set value, the first set value being set below a cavitation saturation point ($R_S$).

3. The method of claim 1, wherein the first time interval is determined to end when the ratio (R) of total bubbles volume ($V_B$) to volume ($V_{VTR}$) inside the vias (20034), trenches (20036) or recessed areas reaches a first set value, the first set value being set at a cavitation saturation point ($R_S$).

4. The method of claim 1, wherein the second time interval is determined to end after the ratio (R) of total bubbles volume ($V_B$) to volume ($V_{VTR}$) inside the vias (20034), trenches (20036) or recessed areas reaches a second set value, the second set value being set much lower than a cavitation saturation point ($R_S$).

**5.** The method of claim 1, wherein a duration of the first time interval is $m\tau_1$, where $\tau_1$ is the time for a ratio (R) of total bubbles volume ($V_B$) to volume ($V_{VTR}$) inside the vias (20034), trenches (20036) or recessed areas to reach a cavitation saturation point ($R_S$), and m is a value between 0.1 to 100.

**6.** The method of claim 1, wherein the first time interval is shorter than $((V_i - V_0 - \Delta V)/(\Delta V - \delta V) + 1)/f_1$, where $V_i$ is a desired volume, $V_0$ is an original volume, $\Delta V$ is a volume compression of the bubble after one time of compression, $\delta V$ is a volume increase of the bubble after one time of expansion, and $f_1$ is the first frequency.

**7.** An apparatus for cleaning a semiconductor wafer (1010; 16010; 17010) comprising vias (20034), trenches (20036) or recessed areas, , the apparatus comprising:

a wafer chuck (1014) configured to hold the semiconductor wafer (1010; 16010; 17010);
an ultra/mega sonic device (1003) positioned adjacent to the semiconductor wafer (1010; 16010; 17010) and consisting of a piezoelectric transducer (1004) acoustically coupled to a resonator (1008);
at least one nozzle (1012) configured to inject a chemical liquid or de-ionized water (1032) on the semiconductor wafer (1010; 16010; 17010) and a gap between the semiconductor wafer (1010; 16010; 17010) and the ultra/mega sonic device (1003);
an ultra/mega sonic power supply;
a controller configured to control the ultra/mega sonic device (1003) to:

set the ultra/mega sonic power supply at a first frequency ($f_1$) and a first power ($P_1$) to drive said ultra/mega sonic device (1003) during a first time interval;
after a ratio (R) of total bubbles volume ($V_B$) to volume ($V_{VTR}$) inside vias (20034), trenches (20036) or recessed areas on the semiconductor wafer (1010; 16010; 17010) increases to a first set value, set the ultra/mega sonic power supply at a second frequency ($f_2$) and a second power ($P_2$) to drive said ultra/mega sonic device (1003) during a second time interval;
after the ratio (R) of total bubbles volume ($V_B$) to volume ($V_{VTR}$) inside the vias (20034), trenches (20036) or recessed areas reduces to a second set value, set the ultra/mega sonic power supply at the first frequency ($f_1$) and the first power ($P_1$) again; and
repeating the above steps until the semiconductor wafer (1010; 16010; 17010) is cleaned.

**8.** The apparatus of claim 7, wherein the first time interval is determined to end when the ratio (R) of total bubbles volume ($V_B$) to volume ($V_{VTR}$) inside the vias (20034), trenches (20036) or recessed areas reaches a first set value, the first set value being set below a cavitation saturation point ($R_S$).

**9.** The apparatus of claim 7, wherein the first time interval is determined to end when the ratio (R) of total bubbles volume ($V_B$) to volume ($V_{VTR}$) inside the vias (20034), trenches (20036) or recessed areas reaches a first set value, the first set value being set at a cavitation saturation point ($R_S$).

**10.** The apparatus of claim 7, wherein the second time interval is determined to end after the ratio (R) of total bubbles volume ($V_B$) to volume ($V_{VTR}$) inside the vias (20034), trenches (20036) or recessed areas reaches a second set value, the second set value being set much lower than a cavitation saturation point ($R_S$).

**11.** The apparatus of claim 7, wherein a duration of the first time interval is $m\tau_1$, where $\tau_1$ is the time for a ratio (R) of total bubbles volume ($V_B$) to volume ($V_{VTR}$) inside the vias (20034), trenches (20036) or recessed areas to reach a cavitation saturation point ($R_S$), and m is a value between 0.1 to 100.

**12.** The apparatus of claim 7, wherein the first time interval is shorter than $((V_i - V_0 - \Delta V)/(\Delta V - \delta V) + 1)/f_1$, where $V_i$ is a desired volume, $V_0$ is an original volume, $\Delta V$ is a volume compression of the bubble after one time of compression, $\delta V$ is a volume increase of the bubble after one time of expansion, and $f_1$ is the first frequency.

**Patentansprüche**

**1.** Verfahren zum Reinigen von Vias, Gräben oder vertieften Bereichen auf einem Substrat unter Verwendung einer Ultra-/Megaschallvorrichtung, wobei das Verfahren umfasst:
Einbringen von Flüssigkeit (1032) in einen Raum zwischen einem Substrat und einer Ultra-/Megaschallvorrichtung (1003);

wobei das Verfahren ferner umfasst:

Einstellen einer Ultra-/Megaschall-Leistungsversorgung auf eine erste Frequenz ($f_1$) und eine erste Leistung ($P_1$), um die Ultra-/Megaschallvorrichtung (1003) während eines ersten Zeitintervalls anzusteuern; nachdem ein Verhältnis (R) des Gesamtblasenvolumens ($V_B$) zu dem Volumen ($V_{VTR}$) innerhalb Vias (20034), Gräben (20036) oder vertiefter Bereiche auf dem Substrat auf einen ersten eingestellten Wert zunimmt, Einstellen der Ultra-/Megaschall-Leistungsversorgung auf eine zweite Frequenz ($f_2$) und eine zweite Leistung ($P_2$), um die Ultra-/Megaschallvorrichtung (1003) während eines zweiten Zeitintervalls anzusteuern; nachdem das Verhältnis (R) des Gesamtblasenvolumens ($V_B$) zu dem Volumen ($V_{VTR}$) innerhalb der Vias (20034), Gräben (20036) oder vertieften Bereiche auf einen zweiten eingestellten Wert abnimmt, erneutes Einstellen der Ultra-/Megaschall-Leistungsversorgung auf die erste Frequenz ($f_1$) und die erste Leistung ($P_1$); und Wiederholen der obigen Schritte, bis das Substrat gereinigt ist.

2. Verfahren nach Anspruch 1, wobei das erste Zeitintervall so bestimmt wird, dass es endet, wenn das Verhältnis (R) des Gesamtblasenvolumens ($V_B$) zu dem Volumen ($V_{VTR}$) innerhalb der Vias (20034), Gräben (20036) oder vertieften Bereiche einen ersten eingestellten Wert erreicht, wobei der erste eingestellte Wert unterhalb eines Kavitationssättigungspunktes ($R_S$) eingestellt ist.

3. Verfahren nach Anspruch 1, wobei das erste Zeitintervall so bestimmt wird, dass es endet, wenn das Verhältnis (R) des Gesamtblasenvolumens ($V_B$) zu dem Volumen ($V_{VTR}$) innerhalb der Vias (20034), Gräben (20036) oder vertieften Bereiche einen ersten eingestellten Wert erreicht, wobei der erste eingestellte Wert bei einem Kavitationssättigungspunkt ($R_S$) eingestellt ist.

4. Verfahren nach Anspruch 1, wobei das zweite Zeitintervall so bestimmt wird, dass es endet, nachdem das Verhältnis (R) des Gesamtblasenvolumens ($V_B$) zu dem Volumen ($V_{VTR}$) innerhalb der Vias (20034), Gräben (20036) oder vertiefen Bereiche einen zweiten eingestellten Wert erreicht, wobei der zweite eingestellte Wert viel niedriger als ein Kavitationssättigungspunkt ($R_S$) eingestellt ist.

5. Verfahren nach Anspruch 1, wobei eine Dauer des ersten Zeitintervalls $m\tau_1$ ist, wobei $\tau_1$ die Zeit ist, dass ein Verhältnis (R) des Gesamtblasenvolumens ($V_B$) zu dem Volumen ($V_{VTR}$) innerhalb der Vias (20034), Gräben (20036) oder vertieften Bereiche einen Kavitationssättigungspunkt (Rs) erreicht, und m ein Wert zwischen 0,1 und 100 ist.

6. Verfahren nach Anspruch 1, wobei das erste Zeitintervall kürzer als $((V_i - V_0 - \Delta V)/( \Delta V - \delta V) + 1)/ f_1$ ist, wobei $V_i$ ein gewünschtes Volumen ist, $V_0$ ein ursprüngliches Volumen ist, $\Delta V$ eine Volumenkompression der Blase nach einmaliger Kompression ist, $\delta V$ eine Volumenzunahme der Blase nach einmaliger Expansion ist und $f_1$ die erste Frequenz ist.

7. Einrichtung zum Reinigen eines Halbleiterwafers (1010; 16010; 17010), der Vias (20034), Gräben (20036) oder vertiefte Bereiche umfasst, wobei die Einrichtung umfasst:

einen Wafer-Chuck (1014), der konfiguriert ist, den Halbleiterwafer (1010; 16010; 17010) zu halten; eine Ultra-/Megaschallvorrichtung (1003), die neben dem Halbleiterwafer (1010; 16010; 17010) positioniert ist und aus einem piezoelektrischen Wandler (1004) besteht, der akustisch mit einem Resonator (1008) gekoppelt ist; mindestens eine Düse (1012), die konfiguriert ist, eine chemische Flüssigkeit oder deionisiertes Wasser (1032) auf den Halbleiterwafer (1010; 16010; 17010) und einen Spalt zwischen dem Halbleiterwafer (1010; 16010; 17010) und der Ultra-/Megaschallvorrichtung (1003) einzuspritzen; eine Ultra-/Megaschall-Leistungsversorgung; eine Steuerung, die konfiguriert ist, die Ultra-/Megaschallvorrichtung (1003) zu steuern zum:

Einstellen der Ultra-/Megaschall-Leistungsversorgung auf eine erste Frequenz ($f_1$) und eine erste Leistung ($P_1$), um die Ultra-/Megaschallvorrichtung (1003) während eines ersten Zeitintervalls anzusteuern; nachdem ein Verhältnis (R) des Gesamtblasenvolumens ($V_B$) zu dem Volumen ($V_{VTR}$) innerhalb Vias (20034), Gräben (20036) oder vertiefter Bereiche auf dem Halbleiterwafer (1010; 16010; 17010) auf einen ersten eingestellten Wert zunimmt, Einstellen der Ultra-/Megaschall-Leistungsversorgung auf eine zweite Frequenz ($f_2$) und eine zweite Leistung ($P_2$), um die Ultra-/Megaschallvorrichtung (1003) während eines zweiten Zeitintervalls anzusteuern;

nachdem das Verhältnis (R) des Gesamtblasenvolumens (VB) zu dem Volumen (VVTR) innerhalb der Vias (20034), Gräben (20036) oder vertieften Bereiche auf einen zweiten eingestellten Wert abnimmt, erneutes Einstellen der Ultra-/Megaschall-Leistungsversorgung auf die erste Frequenz ($f_1$) und die erste Leistung ($P_1$); und

Wiederholen der obigen Schritte, bis der Halbleiterwafer (1010; 16010; 17010) gereinigt ist.

8. Einrichtung nach Anspruch 7, wobei das erste Zeitintervall so bestimmt wird, dass es endet, wenn das Verhältnis (R) des Gesamtblasenvolumens ($V_B$) zu dem Volumen ($V_{VTR}$) innerhalb der Vias (20034), Gräben (20036) oder vertieften Bereiche einen ersten eingestellten Wert erreicht, wobei der erste eingestellte Wert unterhalb eines Kavitationssättigungspunktes ($R_S$) eingestellt ist.

9. Einrichtung nach Anspruch 7, wobei das erste Zeitintervall so bestimmt wird, dass es endet, wenn das Verhältnis (R) des Gesamtblasenvolumens ($V_B$) zu dem Volumen ($V_{VTR}$) innerhalb der Vias (20034), Gräben (20036) oder vertieften Bereiche einen ersten eingestellten Wert erreicht, wobei der erste eingestellte Wert bei einem Kavitationssättigungspunkt ($R_S$) eingestellt ist.

10. Einrichtung nach Anspruch 7, wobei das zweite Zeitintervall so bestimmt wird, dass es endet, nachdem das Verhältnis (R) des Gesamtblasenvolumens ($V_B$) zu dem Volumen ($V_{VTR}$) innerhalb der Vias (20034), Gräben (20036) oder vertieften Bereiche einen zweiten eingestellten Wert erreicht, wobei der zweite eingestellte Wert viel niedriger als ein Kavitationssättigungspunkt ($R_S$) eingestellt ist.

11. Einrichtung nach Anspruch 7, wobei eine Dauer des ersten Zeitintervalls $m\tau_1$ ist, wobei $\tau_1$ die Zeit ist, dass ein Verhältnis (R) des Gesamtblasenvolumens ($V_B$) zu dem Volumen ($V_{VTR}$) innerhalb der Vias (20034), Gräben (20036) oder vertieften Bereiche einen Kavitationssättigungspunkt ($R_S$) erreicht, und m ein Wert zwischen 0,1 und 100 ist.

12. Einrichtung nach Anspruch 7, wobei das erste Zeitintervall kürzer als $((V_i - V_0 - \Delta V)/(\Delta V - \delta V) + 1)/ f_1$ ist, wobei $V_i$ ein gewünschtes Volumen ist, $V_0$ ein ursprüngliches Volumen ist, $\Delta V$ eine Volumenkompression der Blase nach ein-maliger Kompression ist, $\delta V$ eine Volumenzunahme der Blase nach einmaliger Expansion ist und $f_1$ die erste Frequenz ist.

**Revendications**

1. Un procédé de nettoyage de vias, de tranchées ou de zones en retrait sur un substrat à l'aide d'un dispositif ultrasonique/mégasonique, le procédé comprenant :

appliquer un liquide (1032) dans un espace entre un substrat et un dispositif ultrasonique/mégasonique (1003); le procédé comprenant, en outre, les étapes suivantes :

régler l'alimentation ultrasonique/mégasonique à une première fréquence ($f_1$) et à une première puissance ($P_1$) pour actionner ledit dispositif ultrasonique/mégasonique (1003) pendant un premier intervalle de temps; après qu'un rapport (R) du volume total des bulles ($V_B$) au volume ($V_{VTR}$) à l'intérieur des vias (20034), des tranchées (20036) ou des zones en retrait sur le substrat augmente jusqu'à une première valeur fixée, régler ladite alimentation ultrasonique/mégasonique à une seconde fréquence ($f_2$) et une seconde puissance ($P_2$) pour actionner ledit dispositif ultrasonique/mégasonique (1003) pendant un second intervalle de temps; après que le rapport (R) du volume total des bulles ($V_B$) au volume ($V_{VTR}$) à l'intérieur des vias (20034), des tranchées (20036) ou des zones en retrait se réduit à une deuxième valeur fixée, régler de nouveau ladite alimentation ultrasonique/mégasonique à la première fréquence ($f_1$) et à la première puissance ($P_1$); et répéter les étapes ci-dessus jusqu'à ce que le substrat soit nettoyé.

2. Le procédé selon la revendication 1, dans lequel le premier intervalle de temps est déterminé pour se terminer lorsque le rapport (R) du volume total des bulles ($V_B$) au volume ($V_{VTR}$) à l'intérieur des vias (20034), des tranchées (20036) ou des zones en retrait atteint une première valeur fixée, ladite première valeur étant fixée en dessous d'un point de saturation de cavitation (Rs).

3. Le procédé selon la revendication 1, dans lequel le premier intervalle de temps est déterminé comme prenant fin lorsque le rapport (R) du volume total des bulles ($V_B$) au volume ($V_{VTR}$) à l'intérieur des vias (20034), des tranchées (20036) ou des zones en retrait atteint une première valeur fixée, ladite première valeur étant fixée au point de saturation de cavitation (Rs).

4. Le procédé selon la revendication 1, dans lequel le second intervalle de temps est déterminé pour se terminer après que le rapport (R) du volume total des bulles ($V_B$) au volume ($V_{VTR}$) à l'intérieur des vias (20034), des tranchées (20036) ou des zones en retrait atteint une seconde valeur fixée, ladite seconde valeur fixée étant bien en dessous d'un point de saturation de cavitation (Rs).

5. Le procédé selon la revendication 1, dans lequel la durée du premier intervalle de temps est $m\tau_1$, où $\tau_1$ est le temps nécessaire pour qu'un rapport (R) du volume total des bulles ($V_B$) au volume ($V_{VTR}$) à l'intérieur des vias (20034), des tranchées (20036) ou des zones en retrait atteigne un point de saturation de cavitation (Rs), et m est une valeur comprise entre 0,1 et 100.

6. Le procédé selon la revendication 1, dans lequel le premier intervalle de temps est inférieur à $((V_i - V_0 - \Delta V)/(\Delta V - \delta V) + 1)/f_1$, où $V_i$ est un volume souhaité, $V_0$ est un volume initial, $\Delta V$ est une compression de volume de la bulle après un temps de compression, $\delta V$ est une augmentation de volume de la bulle après un temps d'expansion, et $f_1$ est la première fréquence.

7. Un appareil pour nettoyer une plaquette semi-conductrice (1010 ; 16010 ; 17010) comportant des vias (20034), des tranchées (20036) ou des zones en retrait, l'appareil comprenant :

   un mandrin de plaquette (1014) configuré pour maintenir la plaquette semi-conductrice (1010 ; 16010 ; 17010) ;
   un dispositif ultrasonique/mégasonique (1003) positionné à proximité de la plaquette semi-conductrice (1010 ; 16010 ; 17010) et comprenant un transducteur piézoélectrique (1004) couplé acoustiquement à un résonateur (1008) ;
   au moins une buse (1012) configurée pour injecter un liquide chimique ou de l'eau désionisée (1032) sur la plaquette semi-conductrice (1010 ; 16010 ; 17010) et un espace entre la plaquette semi-conductrice (1010 ; 16010 ; 17010) et le dispositif ultrasonique/mégasonique (1003) ;
   une alimentation ultrasonique/mégasonique ;
   un contrôleur configuré pour contrôler le dispositif ultrasonique/mégasonique (1003) afin de :

      régler l'alimentation ultrasonique/mégasonique à une première fréquence ($f_1$) et une première puissance ($P_1$) pour actionner ledit dispositif ultrasonique/mégasonique (1003) pendant un premier intervalle de temps ;
      après qu'un rapport (R) du volume total des bulles ($V_B$) au volume ($V_{VTR}$) à l'intérieur des vias (20034), des tranchées (20036) ou des zones en retrait sur la plaquette semi-conductrice (1010 ; 16010 ; 17010) augmente jusqu'à une première valeur fixée, régler l'alimentation ultrasonique/mégasonique à une seconde fréquence ($f_2$) et une seconde puissance ($P_2$) pour actionner ledit dispositif ultrasonique/mégasonique (1003) pendant un second intervalle de temps ;
      après que le rapport (R) du volume total des bulles ($V_B$) au volume ($V_{VTR}$) à l'intérieur des vias (20034), des tranchées (20036) ou des zones en creux soit réduit à une deuxième valeur fixée, rétablir l'alimentation ultrasonique/mégasonique à la première fréquence ($f_1$) et à la première puissance ($P_1$) ; et
      répéter les étapes ci-dessus jusqu'à ce que la plaquette semi-conductrice (1010 ; 16010 ; 17010) soit nettoyée.

8. L'appareil selon la revendication 7, dans lequel le premier intervalle de temps est déterminé comme prenant fin lorsque le rapport (R) du volume total des bulles ($V_B$) au volume ($V_{VTR}$) à l'intérieur des vias (20034), des tranchées (20036) ou des zones en retrait atteint une première valeur fixée, ladite première valeur étant fixée en dessous d'un point de saturation de cavitation ($R_s$).

9. L'appareil selon la revendication 7, dans lequel le premier intervalle de temps est déterminé pour se terminer lorsque le rapport (R) du volume total des bulles ($V_B$) au volume ($V_{VTR}$) à l'intérieur des vias (20034), des tranchées (20036) ou des zones en retrait atteint une première valeur fixée, ladite première valeur étant fixée au point de saturation de cavitation ($R_s$).

10. L'appareil selon la revendication 7, dans lequel le second intervalle de temps est déterminé pour se terminer après que le rapport (R) du volume total des bulles ($V_B$) au volume ($V_{VTR}$) à l'intérieur des vias (20034), des tranchées (20036) ou des zones en retrait atteint une second valeur fixée, ladite seconde valeur fixée étant bien en dessous d'un point de saturation de cavitation ($R_s$).

11. L'appareil de la revendication 7, dans lequel la durée du premier intervalle de temps est $m\tau_1$, où $\tau_i$ est le temps nécessaire pour qu'un rapport (R) du volume total des bulles ($V_B$) au volume ($V_{VTR}$) à l'intérieur des vias (20034), des tranchées (20036) ou des zones en retrait atteigne un point de saturation de cavitation (Rs), et m est une valeur comprise entre 0,1 et 100.

12. L'appareil selon la revendication 7, dans lequel le premier intervalle de temps est inférieur à $((V_i - V_0 - \Delta V)/(\Delta V - \delta V) + 1)/ f_1$, où $V_i$ est un volume souhaité, $V_0$ est un volume initial, $\Delta V$ est une compression de volume de la bulle après un temps de compression, $\delta V$ est une augmentation de volume de la bulle après un temps d'expansion, et $f_1$ est la première fréquence.

Fig. 1A

EP 3 515 611 B1

Fig. 1 B

2003

Fig. 2D

2003

Fig. 2C

2003

Fig. 2G

3003

Fig. 2B

2003

Fig. 2F

3003

Fig. 2A

2003

Fig. 2E

3012

Initial Sphere

A
B
C
D
E
F
G
H

Wall

Fig. 3A

Fig. 4A

Fig. 4B

Fig. 5A

Fig. 5B

Fig. 5C

EP 3 515 611 B1

EP 3 515 611 B1

Fig.6A

Fig.6B

Fig.6C

Fig.7A

Fig.7B

Fig.7C

Fig.8A

Fig.8B

Fig.8C

Fig.8D

Fig.9A

Fig.9B

Fig.9C

Fig.9D

Fig.10A

Fig.10B

EP 3 515 611 B1

Fig.11A

Fig.11B

Fig.12A

Fig.12B

Fig.13A

Fig.13B

Fig.14A

Fig.14B

EP 3 515 611 B1

Fig. 15A

15034  15010
15046

W

Fig. 15B

15034  15010
15048

W

Fig. 15C

15034  15010

W

Fig. 16

Fig. 17

EP 3 515 611 B1

Fig.18A

Fig.18B

Fig.18C

Fig.19

Fig. 20A

Fig. 20B

Fig. 20C

Fig. 20D

EP 3 515 611 B1

Fig. 20E

Fig. 20F

Fig. 20G

Fig. 20H

20047

20012

20048

W1

Fresh Chemical

EP 3 515 611 B1

Fig. 20I

Fig. 20J

Fig. 21A

Fig. 21B

Fig. 21C

Fig. 21D

EP 3 515 611 B1

Fig.22A

Fig.22B

Fig.22C

Fig.22D

EP 3 515 611 B1

Fig. 23A

Fig. 23B

Fig. 23C

EP 3 515 611 B1

**EP 3 515 611 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4326553 A
- US 6039059 A
- US 6843257 B2

- EP 3298622 A1
- US 2014216508 A1
- CN 2008073471 W